(19) Europäisches Patentamt
European Patent Office
Office européen des brevets

(11) **EP 4 624 481 A1**

(12) **EUROPEAN PATENT APPLICATION**
published in accordance with Art. 153(4) EPC

(43) Date of publication:
**01.10.2025 Bulletin 2025/40**

(21) Application number: **24802552.0**

(22) Date of filing: **08.02.2024**

(51) International Patent Classification (IPC):
***C07F 9/572*** *(2006.01)* ***H10K 30/50*** *(2023.01)*
***H10K 85/50*** *(2023.01)* ***H10K 30/88*** *(2023.01)*

(52) Cooperative Patent Classification (CPC):
Y02E 10/549

(86) International application number:
**PCT/CN2024/076908**

(87) International publication number:
**WO 2024/230264 (14.11.2024 Gazette 2024/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.05.2023 CN 202310496409**

(71) Applicant: **Contemporary Amperex Technology Co., Limited**
**Ningde, Fujian 352100 (CN)**

(72) Inventors:
- **SHI, Ruoxuan**
  **Ningde, Fujian 352100 (CN)**
- **LIU, Xiao**
  **Ningde, Fujian 352100 (CN)**
- **LIANG, Weifeng**
  **Ningde, Fujian 352100 (CN)**
- **CHEN, Changsong**
  **Ningde, Fujian 352100 (CN)**
- **HUANG, Zhihan**
  **Ningde, Fujian 352100 (CN)**
- **LUAN, Bo**
  **Ningde, Fujian 352100 (CN)**
- **GUO, Yongsheng**
  **Ningde, Fujian 352100 (CN)**

(74) Representative: **Frick, Robert**
**Lorenz Seidler Gossel**
**Rechtsanwälte Patentanwälte**
**Partnerschaft mbB**
**Widenmayerstraße 23**
**80538 München (DE)**

(54) **FUNCTIONAL MATERIAL, PASSIVATION FILM, SOLAR CELL, PHOTOVOLTAIC MODULE, AND PHOTOVOLTAIC SYSTEM**

(57) The present application relates to a functional material, a passivation film, a solar cell (10), a photovoltaic module, and a photovoltaic system. The functional compound is represented by formula (1): where formula (2) represents a nitrogen-containing heteroaromatic group having 5 to 60 ring atoms or an aromatic amine group having 6 to 60 ring atoms, substituted by $n_2$ $R_2$ groups, and at least one nitrogen atom in formula (2) is bonded to $n_1$ -$LR_1$ groups; in each occurrence, L is independently selected from linear alkylene group having 1 to 10 carbon atoms; at least one of $R_1$ and $R_2$ is selected from - CHO, -C(O)$R_4$, -C(O)$NH_2$, -C(O)SH, -C(S)SH, -OH, or -SH; $R_4$ is selected from any one of substituted or unsubstituted alkyl group having 1 to 10 carbon atoms; and $n_1$ is an integer ≥ 1, and $n_2$ is an integer ≥ 1.

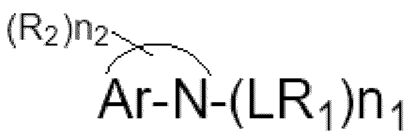
(1)

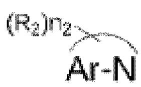
(2)

EP 4 624 481 A1

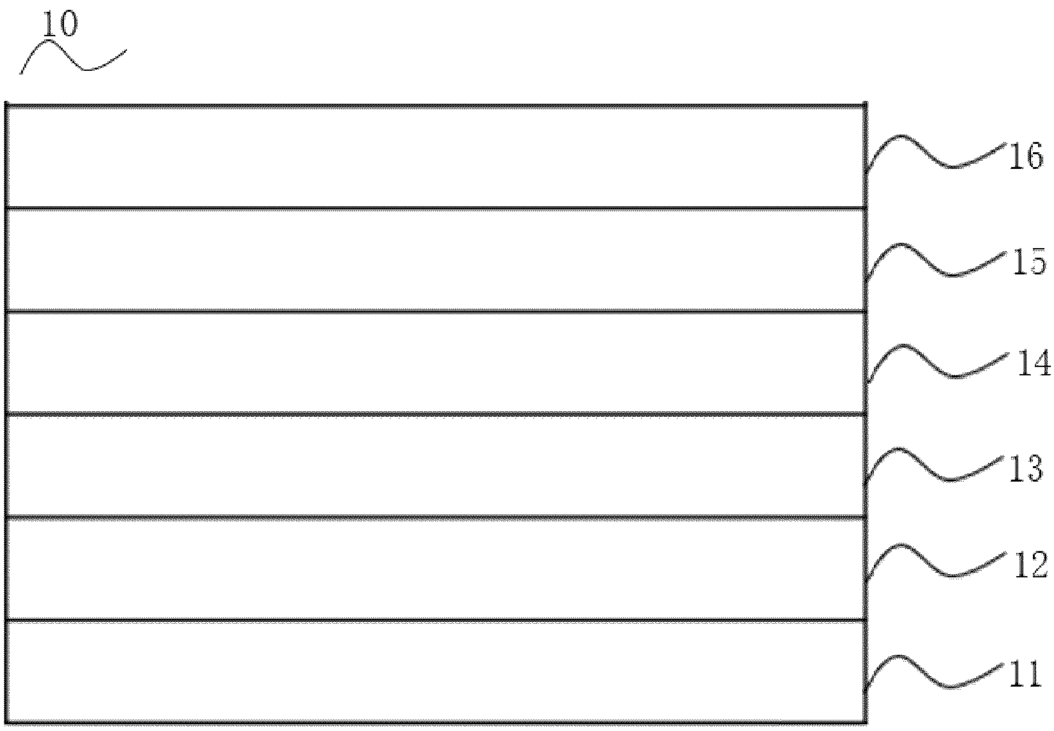


FIG. 1

## Description

### CROSS-REFERENCE TO RELATED APPLICATIONS

The present application refers to Chinese Patent Application No. 202310496409.6, filed on May 5, 2023 and entitled "FUNCTIONAL MATERIAL, PASSIVATION FILM, SOLAR CELL, PHOTOVOLTAIC MODULE, AND PHOTOVOLTAIC SYSTEM", which is incorporated herein by reference in its entirety.

### TECHNICAL FIELD

The present application relates to the technical field of solar cells, and more particularly, to a functional material, a passivation film, a solar cell, a photovoltaic module, and a photovoltaic system.

### BACKGROUND

Perovskite solar cells possess excellent photoelectric properties, high light absorption coefficients, long carrier lifetimes, and extended diffusion lengths, and have become standout performers among third-generation novel solar cells.

However, first, perovskite materials typically exhibit grain boundary defects both within the bulk and at surface interfaces. For instance, perovskite thin films prepared via solution methods are usually polycrystalline, and rapid crystal growth results in structural disorder in perovskite layers. This disordered distribution generates grain boundary defects and crystal defects. These defects not only degrade crystal quality and severely impair carrier transport but also accelerate penetration of moisture/oxygen, hastening degradation of perovskite, thereby adversely affecting both the efficiency and long-term stability of perovskite solar cells. Second, traditional hole transport layer materials are unstable and exhibit excessive defects, for example, metal oxide such as nickel oxide, and therefore reduce the photoelectric conversion efficiency and stability of solar cells.

Therefore, there remains a need for improvement in conventional technologies.

### SUMMARY

In view of this, it is necessary to provide a functional material, a passivation film, a solar cell, a photovoltaic module, and a photovoltaic system aimed at improving the photoelectric conversion efficiency of solar cells.

The present application is realized through the following technical solutions.

According to a first aspect of the present application, a functional compound is provided, where the functional compound is represented by formula (1):

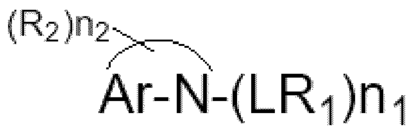

(1)

,

where

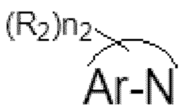

represents a nitrogen-containing heteroaromatic group having 5 to 60 ring atoms or an aromatic amine group having 6 to 60 ring atoms, substituted by $n_2$ $R_2$ groups, and at least one nitrogen atom in

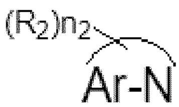

is bonded to $n_1$ -$LR_1$ groups;

in each occurrence, L is independently selected from linear alkylene group having 1 to 10 carbon atoms;
in each occurrence, $R_1$ is independently selected from any one of -CHO, -CN, -C(O)$R_4$, -C(O)OH, -C(O)$NH_2$, - C(O)SH, -C(S)SH, -$NH_2$, -$NO_2$, -OH, -SH, phosphonic acid group, phosphonous acid group, sulfonic acid group, sulfinic acid group, -B$(OH)_2$, and halogen;
in each occurrence, $R_2$ is independently selected from any one of -CHO, -CN, -C(O)$R_4$, -C(O)OH, -C(O)$NH_2$, - C(O)SH, -C(S)SH, -$NH_2$, -$NO_2$, -OH, -SH, phosphonic acid group, phosphonous acid group, sulfonic acid group, sulfinic acid group, boric acid group, halogen, substituted or unsubstituted alkyl group having 1 to 10 carbon atoms, substituted or unsubstituted alkoxy group having 1 to 10 carbon atoms, substituted or unsubstituted alkene group having 2 to 30 carbon atoms, substituted or unsubstituted alkyne group having 2 to 30 carbon atoms, and substituted or unsubstituted aromatic group having 7 to 30 carbon atoms;
in addition, at least one of all $R_1$ and $R_2$ is selected from -CHO, -C(O)$R_4$, -C(O)$NH_2$, -C(O)SH, -C(S)SH, -OH, or -SH;
in each occurrence, $R_4$ is independently selected from any one of substituted or unsubstituted alkyl group having 1 to 10 carbon atoms; and
$n_1$ is an integer ≥ 1, and $n_2$ is an integer ≥ 1.

When the above functional compound is used in the preparation of solar cells, the photoelectric conversion efficiency and stability of the solar cells can be improved. Although the mechanism is not yet fully understood, it is hypothesized that the functional compound possesses a specific group structure, where a core portion includes the nitrogen-containing heteroaromatic group or aromatic amine group that has low hydrophilicity and that is substituted by $n_2$ $R_2$ groups. Additionally, at least one nitrogen atom in the core is bonded to $R_1$ via L, forming an organic whole. L is selected from linear alkylene group having 1 to 10 carbon atoms, and $R_1$ and $R_2$ are specific functional groups that can either be combined with a metal ion such as trivalent nickel, anchor to a hole transport layer, or form hydrogen bond interactions with a A-site cation in perovskite. This enables passivation of metal ions. In addition, L can reduce steric hindrance. The organic compound formed by the organic combination of Ar, L, and $R_1$ can self-assemble through intermolecular interactions to form an aggregate with an ordered structure, thereby enhancing the photoelectric conversion efficiency and stability of solar cells when used in preparation of solar cells.

Furthermore, when the above organic compound is applied to the preparation of a passivation film for solar cells, the presence of L in the functional compound can further enhance the hydrophobicity of the passivation film, thereby further reducing the negative impact of water and oxygen on the perovskite light-absorbing material.

In some embodiments, at least one of all $R_1$ and $R_2$ is selected from -C(O)$NH_2$;

optionally, $n_1 + n_2 \geq 2$, and at least two of all $R_1$ and $R_2$ are selected from -C(O)$NH_2$, and
optionally, $n_1 + n_2 \geq 3$, and at least three of all $R_1$ and $R_2$ are selected from -C(O)$NH_2$.

In some embodiments, at least one of all $R_2$ is selected from -C(O)$NH_2$, and
optionally, $n_2 \geq 2$, and at least two of all $R_2$ are selected from -C(O)$NH_2$.

-C(O)$NH_2$ forms a stronger hydrogen bond and interaction force with the perovskite surface and grain boundary, further enhancing the photoelectric conversion efficiency and stability of solar cells.

In some embodiments, the functional compound is represented by any one of formulas (1-1) to (1-4):

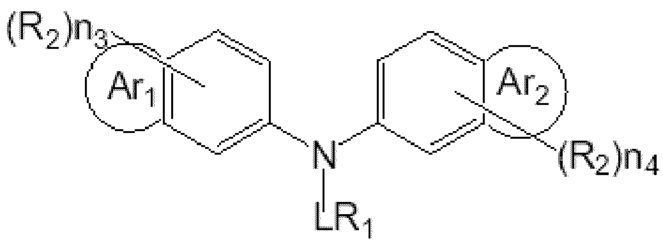

(1-1)

,

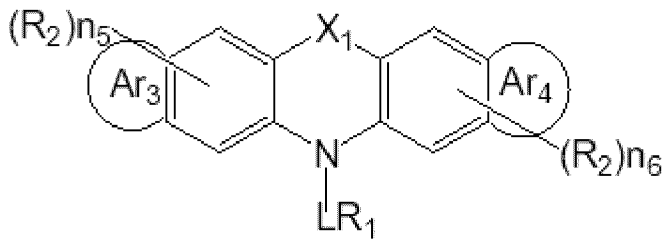

(1-2)

,

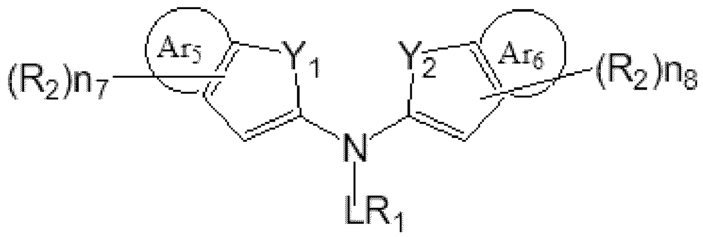

(1-3)

,

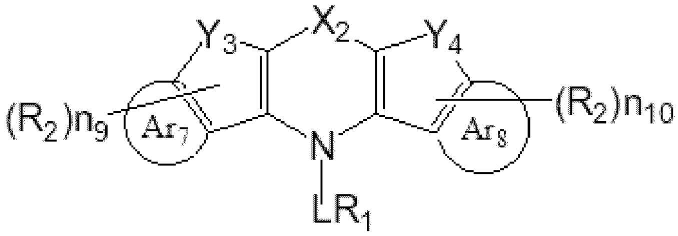

(1-4)

,

where $Ar_1$ to $Ar_8$ are each independently selected from any one of H, substituted or unsubstituted heteroaromatic group having 5 to 40 ring atoms, and substituted or unsubstituted aromatic group having 6 to 40 ring atoms;

$X_1$ to $X_2$ are each independently selected from any one of single bond, $C(R_5R_6)$, O, S, N, C=O, or S=O, and in each occurrence, $R_5$ and $R_6$ are each independently selected from any one of H, D, substituted or unsubstituted alkane group having 1 to 30 carbon atoms, substituted or unsubstituted aromatic group having 6 to 30 carbon atoms, and substituted or unsubstituted heteroaromatic group having 5 to 30 carbon atoms;

$Y_1$ to $Y_4$ are each independently selected from any one of $C(R_7R_8)$, O, S, N, C=O, or S=O, and in each occurrence, $R_7$ and $R_8$ are each independently selected from any one of H, D, substituted or unsubstituted alkane group having 1 to 30 carbon atoms, substituted or unsubstituted aromatic group having 6 to 30 carbon atoms, and substituted or unsubstituted heteroaromatic group having 5 to 30 carbon atoms; and

$n_3$ to $n_{10}$ are each independently an integer $\geq 0$, $n_3 + n_4 \geq 1$, $n_5 + n_6 \geq 1$, $n_7 + n_8 \geq 1$, and $n_9 + n_{10} \geq 1$.

In some embodiments, in formula (1-1), $Ar_1$ and $Ar_2$ are identically selected from any one of H, substituted or unsubstituted heteroaromatic group having 5 to 40 ring atoms, and substituted or unsubstituted aromatic group having 6 to 40 ring atoms;

optionally, in formula (1-1), $Ar_1$ and $Ar_2$ are identically selected from any one of H, substituted or unsubstituted heteroaromatic group having 5 to 30 ring atoms, and substituted or unsubstituted aromatic group having 6 to 30 ring atoms; and

optionally, in formula (1-1), $Ar_1$ and $Ar_2$ are identically selected from any one of H, substituted or unsubstituted heteroaromatic group having 5 to 15 ring atoms, and substituted or unsubstituted aromatic group having 6 to 15 ring atoms.

In some embodiments, formula (1-2) satisfies at least one of the following conditions (1) and (2):

(1) in formula (1-2), $Ar_3$ and $Ar_4$ are identically selected from any one of H, substituted or unsubstituted heteroaromatic

group having 5 to 40 ring atoms, and substituted or unsubstituted aromatic group having 6 to 40 ring atoms,

optionally, $Ar_3$ and $Ar_4$ are identically selected from any one of H, substituted or unsubstituted heteroaromatic group having 5 to 30 ring atoms, and substituted or unsubstituted aromatic group having 6 to 30 ring atoms, and
optionally, $Ar_3$ and $Ar_4$ are identically selected from any one of H, substituted or unsubstituted heteroaromatic group having 5 to 15 ring atoms, and substituted or unsubstituted aromatic group having 6 to 15 ring atoms; and

(2) in formula (1-2), $X_1$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms,

optionally, $X_1$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms, and
optionally, $X_1$ is selected from any one of single bond and O.

In some embodiments, formula (1-3) satisfies at least one of the following conditions (3) and (4):

(3) in formula (1-3), $Ar_8$ and $Ar_6$ are identically selected from any one of H, substituted or unsubstituted heteroaromatic group having 5 to 40 ring atoms, and substituted or unsubstituted aromatic group having 6 to 40 ring atoms,
optionally, $Ar_5$ and $Ar_6$ are identically selected from any one of H, substituted or unsubstituted heteroaromatic group having 5 to 30 ring atoms, and substituted or unsubstituted aromatic group having 6 to 30 ring atoms, and
optionally, $Ar_5$ and $Ar_6$ are identically selected from any one of H, substituted or unsubstituted heteroaromatic group having 5 to 15 ring atoms, and substituted or unsubstituted aromatic group having 6 to 15 ring atoms; and
(4) in formula (1-3), $Y_1$ and $Y_2$ are identically selected from any one of $C(R_7R_8)$, O, S, N, C=O, or S=O, and in each occurrence, $R_7$ and $R_8$ are each independently selected from any one of H, D, substituted or unsubstituted alkane group having 1 to 15 carbon atoms, substituted or unsubstituted aromatic group having 6 to 15 carbon atoms, and substituted or unsubstituted heteroaromatic group having 5 to 15 carbon atoms.

In some embodiments, formula (1-4) satisfies at least one of the following conditions (5) to (7):

(5) in formula (1-4), $Ar_7$ and $Ar_8$ are identically selected from any one of H, substituted or unsubstituted heteroaromatic group having 5 to 40 ring atoms, and substituted or unsubstituted aromatic group having 6 to 40 ring atoms,
optionally, $Ar_7$ and $Ar_8$ are identically selected from any one of H, substituted or unsubstituted heteroaromatic group having 5 to 30 ring atoms, and substituted or unsubstituted aromatic group having 6 to 30 ring atoms, and
optionally, $Ar_7$ and $Ar_8$ are identically selected from any one of H, substituted or unsubstituted heteroaromatic group having 5 to 15 ring atoms, and substituted or unsubstituted aromatic group having 6 to 15 ring atoms;
(6) in formula (1-4), $Y_3$ and $Y_4$ are identically selected from any one of $C(R_7R_8)$, O, S, N, C=O, or S=O, and in each occurrence, $R_7$ and $R_8$ are each independently selected from any one of H, D, substituted or unsubstituted alkane group having 1 to 15 carbon atoms, substituted or unsubstituted aromatic group having 6 to 15 carbon atoms, and substituted or unsubstituted heteroaromatic group having 5 to 15 carbon atoms; and
(7) in formula (1-4), $X_2$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms,
optionally, $X_2$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms, and
optionally, $X_2$ is selected from any one of single bond and O.

In some embodiments, in formulas (1-1) and (1-3), the two connection sites "*" in the

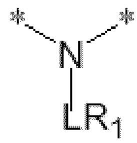

structure are bonded to a same group; and in formulas (1-2) and (1-4), the two fusion sites "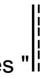" in the

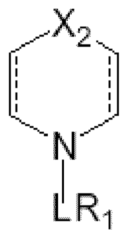

structure are fused with a same group.

In some embodiments, the functional compound is represented by any one of formulas (1a) to (1e):

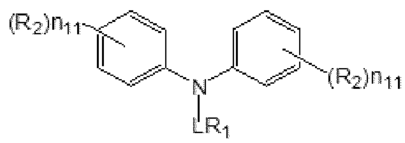

(1a)

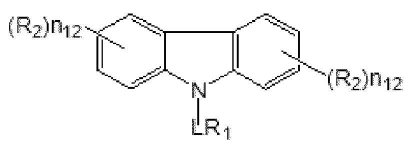

(1b)

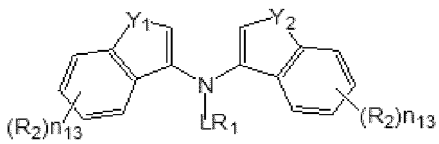

(1c)

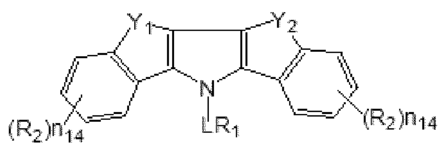

(1d)

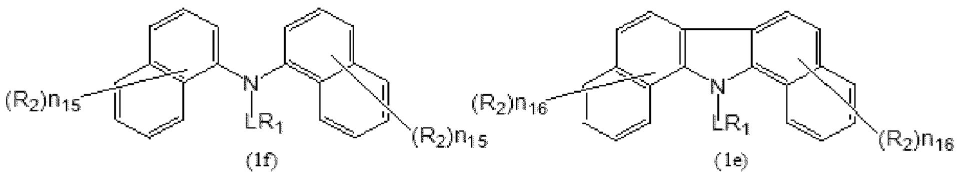

(1f)

(1e)

,

where in each occurrence, $n_{11}$ or $n_{13}$ is each independently selected from any one of integers of 1 to 5, in each occurrence, $n_{12}$ or $n_{14}$ is each independently selected from any one of integers of 1 to 4, and in each occurrence, $n_{15}$ and $n_{16}$ is each independently selected from any one of integers of 1 to 6.

In some embodiments, in each occurrence, L is independently selected from linear alkylene group having 1 to 10 carbon atoms;

optionally, in each occurrence, L is independently selected from linear alkylene group having 2 to 8 carbon atoms;
optionally, in each occurrence, L is independently selected from linear alkylene group having 2 to 6 carbon atoms; and
optionally, in each occurrence, L is independently selected from linear alkylene group having 3 to 5 carbon atoms.

With the length of the carbon chain in L further regulated, the functional compound maintains good hydrophobicity while achieving excellent self-assembly alignment, thereby further improving the photoconversion efficiency and stability of solar cells.

In some embodiments, in each occurrence, $R_2$ is independently selected from any one of -CHO, -CN, $-C(O)R_4$, -C(O)OH, $-C(O)NH_2$, -C(O)SH, -C(S)SH, $-NH_2$, $-NO_2$, -OH, -SH, phosphonic acid group, phosphonous acid group, sulfonic acid group, sulfinic acid group, $-B(OH)_2$, halogen, unsubstituted alkyl group having 1 to 10 carbon atoms, halogen-substituted alkyl group having 1 to 10 carbon atoms, unsubstituted alkoxy group having 1 to 10 carbon atoms, halogen-substituted alkoxy group having 1 to 10 carbon atoms, unsubstituted alkene group having 2 to 10 carbon atoms, unsubstituted alkyne group having 2 to 10 carbon atoms, unsubstituted aromatic group having 6 to 30 carbon atoms, and halogen-substituted aromatic group having 6 to 30 carbon atoms; and
optionally, in each occurrence, $R_2$ is independently selected from any one of phosphonic acid group, phosphonous acid group, sulfonic acid group, sulfinic acid group, $-B(OH)_2$, halogen, unsubstituted alkane group having 1 to 10 carbon atoms, halogen-substituted alkane group having 1 to 10 carbon atoms, unsubstituted alkoxy group having 1 to 10 carbon atoms, halogen-substituted alkoxy group having 1 to 10 carbon atoms, unsubstituted alkene group having 2 to 10 carbon atoms, unsubstituted alkyne group having 2 to 10 carbon atoms, unsubstituted aromatic group having 6 to 15 carbon atoms, and halogen-substituted aromatic group having 6 to 15 carbon atoms.

In some embodiments, $R_4$ is selected from any one of substituted or unsubstituted alkane group having 1 to 5 carbon atoms;

optionally, $R_4$ is selected from unsubstituted alkane group having 1 to 5 carbon atoms; and
optionally, $R_4$ is selected from unsubstituted alkane group having 1 to 3 carbon atoms.

In some embodiments, the functional compound includes at least one of the following A to L:

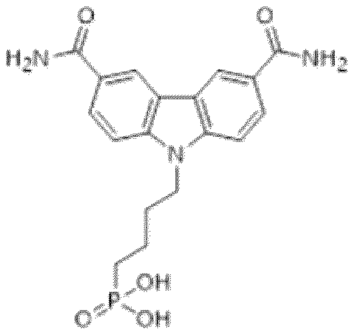

A

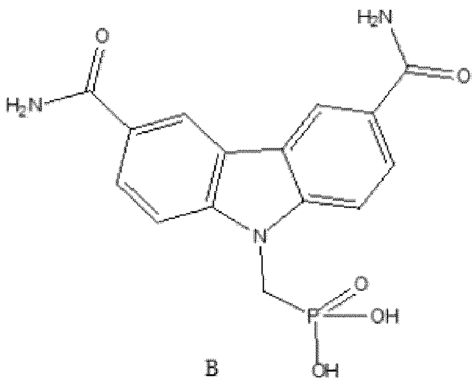

B

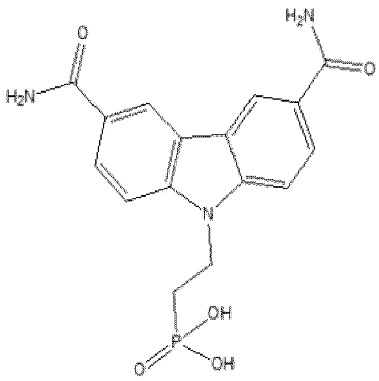

C

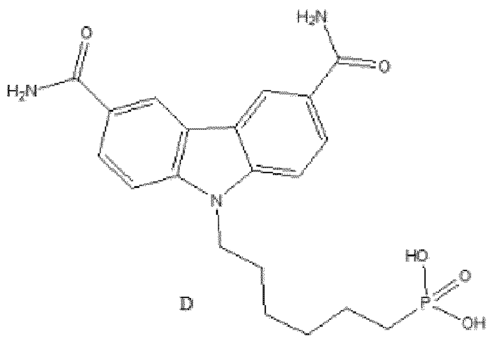

D

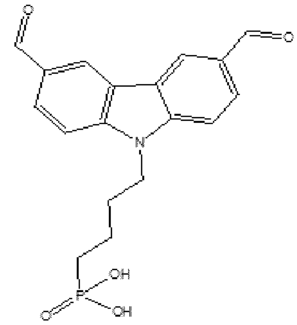

E

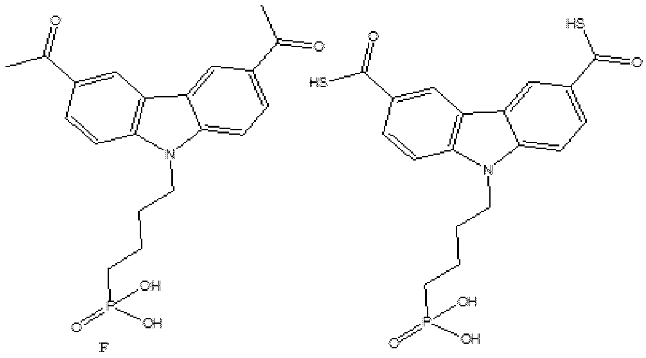

F

G

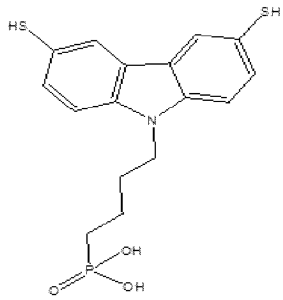

H

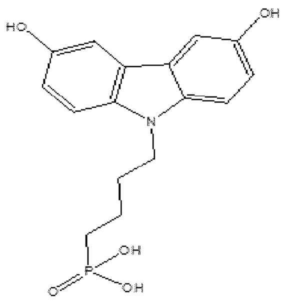

I

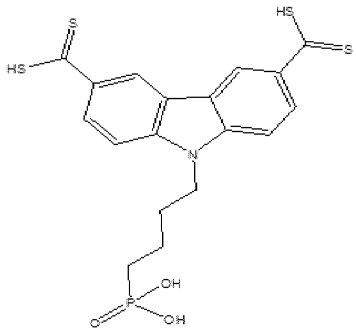

J

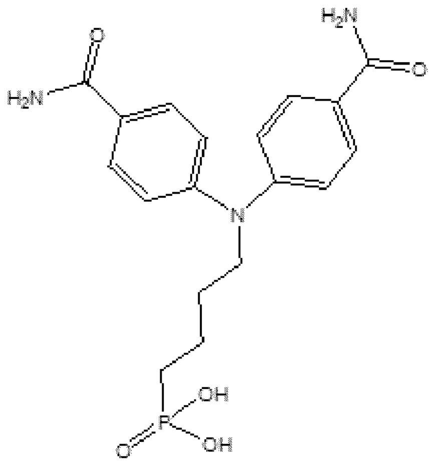

K

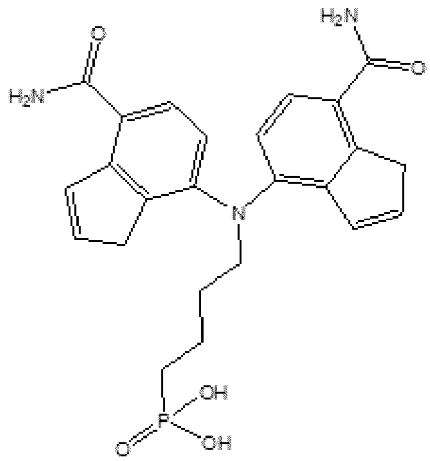

L

According to a second aspect of the present application, a passivation film is provided, where a component of the passivation film includes the functional compound of the first aspect.

According to a third aspect of the present application, a solar cell is provided, where the solar cell includes a hole transport layer, a passivation layer, and a perovskite light-emitting layer that are stacked, and a component of the passivation layer includes the functional compound of the first aspect.

According to a fourth aspect of the present application, a photovoltaic module is provided, including the solar cell of the third aspect.

According to a fifth aspect of the present application, a photovoltaic system is provided, including the photovoltaic module of the fourth aspect.

## BRIEF DESCRIPTION OF DRAWINGS

To describe the technical solutions of the embodiments of the present application more clearly, the following briefly describes the accompanying drawings required for describing the embodiments of the present application.

Apparently, the accompanying drawings described below show merely some embodiments of the present application, and persons of ordinary skill in the art may still derive other drawings from the accompanying drawings without creative efforts: FIG. 1 is a schematic diagram of a solar cell according to an embodiment of the present application.

Reference signs:

10. solar cell; 11. first electrode; 12. hole transport layer; 13. passivation layer; 14. perovskite layer; 15. electron transport layer; and 16. second electrode.

## DESCRIPTION OF EMBODIMENTS

The following describes in detail the embodiments of technical solutions in the present application with reference to the accompanying drawings. The following embodiments are merely intended for a clearer description of the technical solutions of the present application and therefore are used as examples that do not constitute any limitations on the protection scope of the present application.

Unless otherwise defined, all technical and scientific terms used herein shall have the same meanings as commonly understood by those skilled in the art to which the present application belongs. The terms used herein are merely intended to describe the specific embodiments but not intended to constitute any limitation on the present application. The terms "include", "comprise", and "having" and any other variations thereof in the specification, the claims and the foregoing brief description of drawings of the present application are intended to cover a non-exclusive inclusion.

In the description of the embodiments of the present application, the terms "first", "second" and the like are merely intended to distinguish between different objects, and shall not be understood as any indication or implication of relative importance or any implicit indication of the number, specific sequence or primary-secondary relationship of the technical features indicated. In the description of the embodiments of the present application, "a plurality of" means at least two unless otherwise specifically stated.

In this specification, reference to "embodiment" means that specific features, structures, or characteristics described with reference to the embodiment may be incorporated in at least one embodiment of the present application. The word "embodiment" appearing in various places in the specification does not necessarily refer to the same embodiment or an independent or alternative embodiment that is exclusive of other embodiments. Persons skilled in the art explicitly and implicitly understand that the embodiments described herein may be combined with other embodiments.

In the description of the embodiments of the present application, the term "and/or" is only an associative relationship for describing associated objects, indicating that three relationships may be present. For example, A and/or B may indicate the following three cases: presence of only A, presence of both A and B, and presence of only B. In addition, a character "/" in this specification generally indicates an "or" relationship between contextually associated objects.

In the description of the embodiments of the present application, the term "a plurality of" means more than two (inclusive). Similarly, "a plurality of groups" means more than two (inclusive) groups, and "a plurality of pieces" means more than two (inclusive) pieces.

In the description of the embodiments of the present application, the orientations or positional relationships indicated by technical terms such as "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", and the like are based on the orientations or positional relationships as shown in the accompanying drawings. These terms are merely for ease and brevity of description of the embodiments of the present application rather than indicating or implying that the means or components mentioned must have specific orientations or must be constructed or manipulated according to specific orientations, and therefore shall not be construed as any limitation on the embodiments of the present application.

In the description of the embodiments of the present application, unless otherwise specified and defined explicitly, the terms "mount", "connect", "join", and "fasten" should be understood in their general senses. For example, they may refer to a fixed connection, a detachable connection, or an integral connection, may refer to a mechanical connection or electrical connection, any may refer to a direct connection, an indirect connection via an intermediate medium, or an interaction between two elements. Persons of ordinary skill in the art can understand specific meanings of these terms in the embodiments of the present application as suitable to specific situations.

In the present application, the term "alkane group" refers to a group formed by alkane losing one hydrogen atom. For example, methane losing one hydrogen atom forms a methyl group. "Alkylene group or alkylene" refers to a group formed by alkane losing two hydrogen atoms. For example, methane losing two hydrogen atoms forms a methylene group.

The term "linear alkane" refers to an alkane in which carbon atoms are connected by carbon-carbon single bonds and do not form a ring, with the remaining valence bonds bonded to hydrogen, including straight-linear alkanes and branched alkanes.

In the present application, the number of carbon atoms in a "linear alkylene group" can be 1 to 10, including 1, 2, 3, 4, 5, 6, 7, 8, 9, or 10, referring to a group formed by linear alkane having 1 to 10 carbon atoms (that is, C1-10 linear alkane) losing two hydrogen atoms. Specific examples include a group formed by C1 linear alkane, C2 linear alkane, C3 linear alkane, C4 linear alkane, C5 linear alkane, C6 linear alkane, C7 linear alkane, C8 linear alkane, C9 linear alkane, or C10 linear alkane losing two hydrogen atoms. Non-limiting examples of "C1-10 linear alkane" include methane, ethane, n-propane, isopropane, n-butane, isobutane, 2-ethylbutane, 3,3-dimethylbutane, n-pentane, isopentane, neopentane, 1-methylpentane, 3-methylpentane, 2-ethylpentane, 4-methyl-2-pentane, n-hexane, 1-methylhexane, 2-ethylhexane, 2-butylhexane, n-heptane, 1-methylheptane, 2,2-dimethylheptane, 2-ethylheptane, n-octane, n-nonane, and n-decane. In other words, non-limiting examples of "C1-10 linear alkylene group" include groups formed by the above linear alkane losing two hydrogen atoms.

In the present application, "number of ring atoms" indicates the number of atoms bonded into a ring. When the ring is substituted by a substituent, atoms included in the substituent are not included in the ring-forming atoms. The same applies to the "number of ring atoms" as described below, unless otherwise specified. For example, a benzene ring has 6 ring atoms, a naphthalene ring has 10 ring atoms, and thiophene has 5 ring atoms.

An "aromatic group" refers to a hydrocarbon group containing at least one aromatic ring, including a non-fused aryl group and a fused aryl group. A fused aryl group refers to a group formed by two or more aromatic rings connected through two shared adjacent ring atoms, that is, a fused ring.

A "heteroaromatic group" refers to a group in which at least one ring-forming atom is a heteroatom and possesses aromaticity. The heteroatom includes, but is not limited to, N, P, O, and S.

An "aromatic amine group" refers to a group formed by a nitrogen atom directly connected to a ring-forming atom in the above aromatic group through a chemical bond.

Non-limiting examples of "aromatic group" in the present application include: benzene, naphthalene, anthracene, fluoranthene, phenanthrene, benzophenanthrene, perylene, tetracene, pyrene, benzopyrene, acenaphthene, or fluorene. Non-limiting examples of "heteroaromatic group" include: triazine, pyridine, pyrimidine, imidazole, furan, thiophene, benzofuran, benzothiophene, indole, carbazole, pyrroloimidazole, pyrrolopyrrole, thienopyrrole, thienothiophene, furanopyrrole, furanofuran, thienofuran, benzoisoxazole, benzoisothiazole, benzoimidazole, quinoline, isoquinoline, phthalazine, quinoxaline, phenanthridine, perimidine, quinazoline, quinazolinone, dibenzofuran, dibenzothiophene, or carbazole. Non-limiting examples of "aromatic amine group" include: substituted or unsubstituted aniline, substituted or unsubstituted diphenylamine, or substituted or unsubstituted triphenylamine.

In the present application, when a connection site is not specified for a group, it indicates that any connectable site in the group can serve as the connection site.

In the present application, when a single bond connected to a substituent passes through the corresponding ring, it indicates that the substituent can be connected to any substitutable site on the ring. For example, in

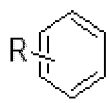

, R is connected to any one of substitutable sites on the benzene ring, and when R is H, it indicates the absence of a substituent, and

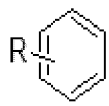

is a benzene ring.

In the present application, "substituted or unsubstituted" means that the defined group may or may not be substituted. When the defined group is substituted, it should be understood as optionally substituted by acceptable groups in the art, including but not limited to: C1-30 alkyl, heterocyclic group containing 3-20 ring atoms, aryl group containing 5-20 ring atoms, heteroaryl group containing 5-20 ring atoms, and halogen.

In the present application, when the same substituent appears multiple times, it can be independently selected from different groups. For example, in

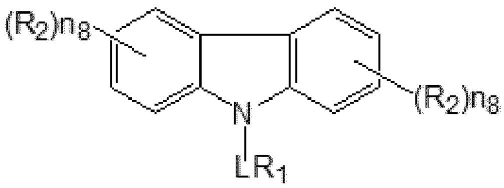

, when multiple $R_2$ are present, each $R_3$ and $R_2$ can be independently selected from different groups.

In the present application, when two groups are connected by a single connection point, for example, in

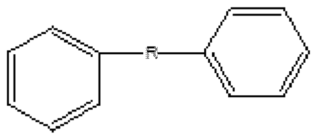

,

when R is selected as a single bond, it means that the two groups are directly connected by a single bond without a specific group, that is,

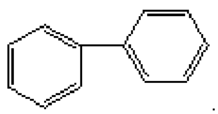

.

In the present application, when two cyclic structures in a structural schematic share at least two ring-forming atoms, it indicates that the two cyclic structures are fused. If one of the cyclic structure groups is selected as H, it indicates that the cyclic structure does not exist. For example, in

"

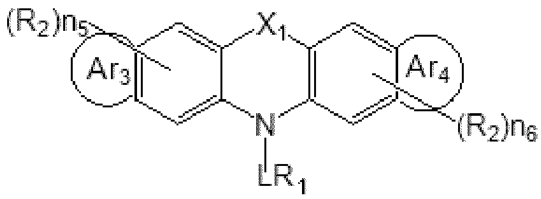

(1-2) ",

when $Ar_3$ or $Ar_4$ is selected as H, it indicates that $Ar_3$ or $Ar_4$ does not exist. When both $Ar_3$ and $Ar_4$ are H, the structure is "

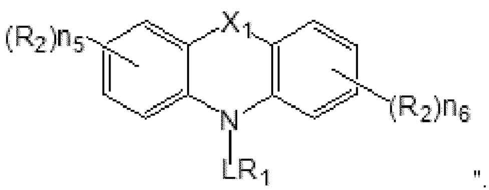

".

An embodiment of the present application provides a functional compound represented by formula (1):

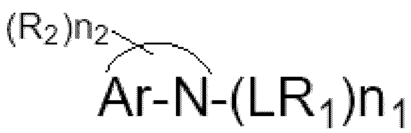

(1)

,

where

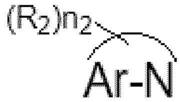

represents a nitrogen-containing heteroaromatic group having 5 to 60 ring atoms or an aromatic amine group having 6 to 60 ring atoms, substituted by $n_2$ $R_2$ groups, and at least one nitrogen atom in

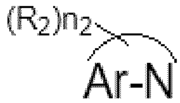

is bonded to $n_1$ $-LR_1$ groups;

in each occurrence, L is independently selected from linear alkylene group having 1 to 10 carbon atoms;

in each occurrence, $R_1$ is independently selected from any one of -CHO, -CN, $-C(O)R_4$, -C(O)OH, $-C(O)NH_2$, - C(O)SH, -C(S)SH, $-NH_2$, $-NO_2$, -OH, -SH, phosphonic acid group, phosphonous acid group, sulfonic acid group, sulfinic acid group, $-B(OH)_2$, and halogen;

in each occurrence, $R_2$ is independently selected from any one of -CHO, -CN, $-C(O)R_4$, -C(O)OH, $-C(O)NH_2$, - C(O)SH, -C(S)SH, $-NH_2$, $-NO_2$, -OH, -SH, phosphonic acid group, phosphonous acid group, sulfonic acid group, sulfinic acid group, boric acid group, halogen, substituted or unsubstituted alkyl group having 1 to 10 carbon atoms, substituted or unsubstituted alkoxy group having 1 to 10 carbon atoms, substituted or unsubstituted alkene group having 2 to 30 carbon atoms, substituted or unsubstituted alkyne group having 2 to 30 carbon atoms, and substituted or unsubstituted aromatic group having 7 to 30 carbon atoms;

in addition, at least one of all $R_1$ and $R_2$ is selected from -CHO, $-C(O)R_4$, $-C(O)NH_2$, -C(O)SH, -C(S)SH, -OH, or -SH;

$R_4$ is selected from any one of substituted or unsubstituted alkyl group having 1 to 10 carbon atoms; and

$n_1$ is an integer $\geq 1$, and $n_2$ is an integer $\geq 1$.

When the above functional compound is used in the preparation of solar cells, the photoelectric conversion efficiency and stability of the solar cells can be improved. Although the mechanism is not yet fully understood, it is hypothesized that the functional compound possesses a specific group structure, where a core portion includes the nitrogen-containing heteroaromatic group or aromatic amine group that has low hydrophilicity and that is substituted by $n_2$ $R_2$ groups. Additionally, at least one nitrogen atom in the core is bonded to $R_1$ via L, forming an organic whole. L is selected from linear alkylene group having 1 to 10 carbon atoms, and $R_1$ and $R_2$ are specific functional groups that can either be combined with a metal ion such as trivalent nickel, anchor to a hole transport layer, or form hydrogen bond interactions with a A-site cation in perovskite. This enables passivation of metal ions. In addition, L can reduce steric hindrance. The organic compound formed by the organic combination of Ar, L, and $R_1$ can self-assemble through intermolecular interactions to form an aggregate with an ordered structure, thereby enhancing the photoelectric conversion efficiency and stability of solar cells when used in preparation of solar cells.

Furthermore, when the above organic compound is applied to the preparation of a passivation film for solar cells, the presence of L in the functional compound can further enhance the hydrophobicity of the passivation film, thereby further reducing the negative impact of water and oxygen on the perovskite light-absorbing material.

It can be understood that the number of sites on the nitrogen atom in

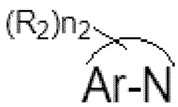

theoretically capable of bonding to $-LR_1$ is the upper limit of $n_1$ $n_1$

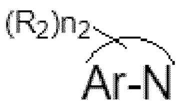

represents a nitrogen-containing heteroaromatic group having 5 to 60 ring atoms or an aromatic amine group having 6 to 60 ring atoms, substituted by $n_2$ $R_2$ groups. The specific upper limit of $n_1$ can be determined based on the arrangement position of the nitrogen atom, for example, it can be 1, such as in a carbazole group, or 2, such as in an aniline group. Similarly, the upper limit of $n_2$ is the number of substitutable sites on the nitrogen-containing heteroaromatic group having 5

to 60 ring atoms or the aromatic amine group having 6 to 60 ring atoms.

In some embodiments, at least one of all $R_1$ and $R_2$ is selected from -C(O)$NH_2$.

In some embodiments, $n_1 + n_2 \geq 2$, and at least two of all $R_1$ and $R_2$ are selected from -C(O)$NH_2$.

In some embodiments, $n_1 + n_2 \geq 3$, and at least three of all $R_1$ and $R_2$ are selected from -C(O)$NH_2$.

In some embodiments, $n_1 + n_2 \geq 4$, and at least four of all $R_1$ and $R_2$ are selected from -C(O)$NH_2$.

In some embodiments, at least one of all $R_2$ is selected from -C(O)$NH_2$.

Optionally, $n_2 \geq 2$, and at least two of all $R_2$ are selected from -C(O)$NH_2$.

Optionally, $n_2 \geq 3$, and at least three of all $R_2$ are selected from -C(O)$NH_2$.

Optionally, $n_2 \geq 4$, and at least four of all $R_2$ are selected from -C(O)$NH_2$.

-C(O)$NH_2$ forms a stronger hydrogen bond and interaction force with the perovskite surface and grain boundary, further enhancing the photoelectric conversion efficiency and stability of solar cells.

In some embodiments,

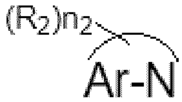

represents a nitrogen-containing heteroaromatic group having 5 to 40 ring atoms or an aromatic amine group having 6 to 40 ring atoms, substituted by $n_2$ $R_2$ groups.

In some embodiments,

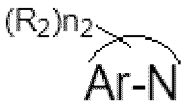

represents a nitrogen-containing heteroaromatic group having 6 to 30 ring atoms or an aromatic amine group having 6 to 30 ring atoms, substituted by $n_2$ $R_2$ groups.

In some embodiments,

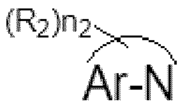

represents a nitrogen-containing heteroaromatic group having 6 to 15 ring atoms or an aromatic amine group having 6 to 25 ring atoms, substituted by $n_2$ $R_2$ groups.

In some embodiments, the functional compound is represented by any one of formulas (1-1) to (1-4):

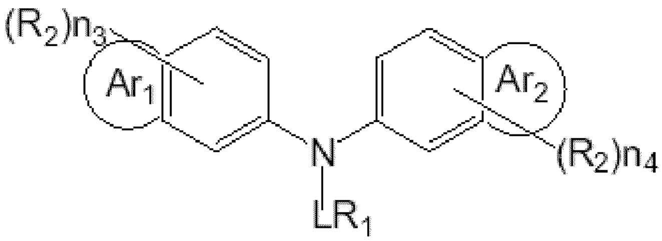

(1-1)

,

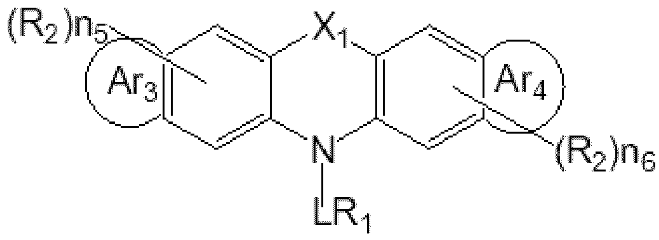

(1-2)

,

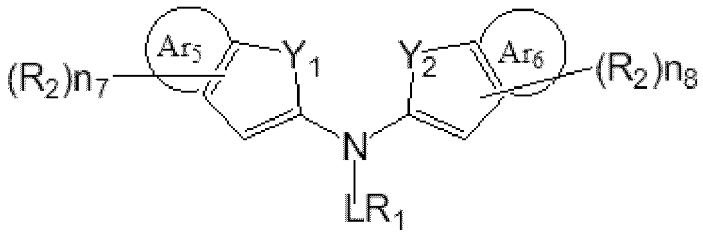

(1-3)

,

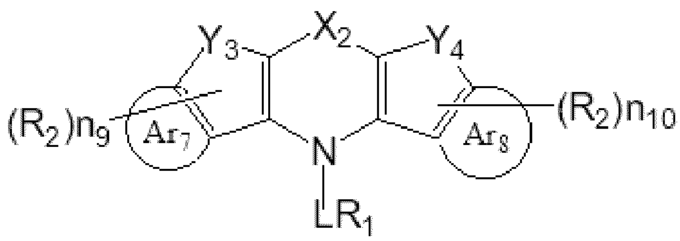

(1-4)

,

where $Ar_1$ to $Ar_8$ are each independently selected from any one of H, substituted or unsubstituted heteroaromatic group having 5 to 40 ring atoms, and substituted or unsubstituted aromatic group having 6 to 40 ring atoms;

$X_1$ to $X_2$ are each independently selected from any one of single bond, $C(R_5R_6)$, O, S, N, C=O, or S=O, and in each occurrence, $R_5$ and $R_6$ are each independently selected from any one of H, D, substituted or unsubstituted alkane group having 1 to 30 carbon atoms, substituted or unsubstituted aromatic group having 6 to 30 carbon atoms, and substituted or unsubstituted heteroaromatic group having 5 to 30 carbon atoms;

$Y_1$ to $Y_4$ are each independently selected from any one of $C(R_7R_8)$, O, S, N, C=O, or S=O, and in each occurrence, $R_7$ and $R_8$ are each independently selected from any one of H, D, substituted or unsubstituted alkane group having 1 to 30 carbon atoms, substituted or unsubstituted aromatic group having 6 to 30 carbon atoms, and substituted or unsubstituted heteroaromatic group having 5 to 30 carbon atoms; and

$n_3$ to $n_{10}$ are each independently an integer $\geq 0$, $n_3 + n_4 \geq 1$, $n_5 + n_6 \geq 1$, $n_7 + n_8 \geq 1$, and $n_9 + n_{10} \geq 1$.

The upper limits of $n_3$ to $n_{10}$ is determined in the same manner as the upper limits of $n_1$ and $n_2$, depending on the number of connectable sites on the group or the connected atom, and is not repeated herein again.

In some embodiments, in formula (1-1), $Ar_1$ and $Ar_2$ are identically selected from any one of H, substituted or unsubstituted heteroaromatic group having 5 to 40 ring atoms, and substituted or unsubstituted aromatic group having 6 to 40 ring atoms.

In some embodiments, in formula (1-1), $Ar_1$ and $Ar_2$ are identically selected from any one of H, substituted or unsubstituted heteroaromatic group having 5 to 30 ring atoms, and substituted or unsubstituted aromatic group having 6 to 30 ring atoms.

In some embodiments, in formula (1-1), $Ar_1$ and $Ar_2$ are identically selected from any one of H, substituted or unsubstituted heteroaromatic group having 5 to 15 ring atoms, and substituted or unsubstituted aromatic group having 6 to 15 ring atoms.

In some embodiments, in formula (1-1), $Ar_1$ and $Ar_2$ are identically selected from any one of H, unsubstituted heteroaromatic group having 5 to 15 ring atoms, and unsubstituted aromatic group having 6 to 15 ring atoms.

In some embodiments, in formula (1-1), $Ar_1$ and $Ar_2$ are identically selected from any one of H, phenyl, naphthyl,

anthracyl, pyridyl, pyrimidyl, imidazolyl, furyl, thienyl, and carbazolyl.

In some embodiments, in formula (1-2), $Ar_3$ and $Ar_4$ are identically selected from any one of H, substituted or unsubstituted heteroaromatic group having 5 to 40 ring atoms, and substituted or unsubstituted aromatic group having 6 to 40 ring atoms.

In some embodiments, in formula (1-2), $Ar_3$ and $Ar_4$ are identically selected from any one of H, substituted or unsubstituted heteroaromatic group having 5 to 30 ring atoms, and substituted or unsubstituted aromatic group having 6 to 30 ring atoms.

In some embodiments, in formula (1-2), $Ar_3$ and $Ar_4$ are identically selected from any one of H, substituted or unsubstituted heteroaromatic group having 5 to 15 ring atoms, and substituted or unsubstituted aromatic group having 6 to 15 ring atoms.

In some embodiments, in formula (1-2), $Ar_3$ and $Ar_4$ are identically selected from any one of H, unsubstituted heteroaromatic group having 5 to 15 ring atoms, and unsubstituted aromatic group having 6 to 15 ring atoms.

In some embodiments, in formula (1-2), $Ar_3$ and $Ar_4$ are identically selected from any one of H, phenyl, naphthyl, anthracyl, pyridyl, pyrimidyl, imidazolyl, furyl, thienyl, and carbazolyl.

In some embodiments, in formula (1-2), $X_1$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms.

In some embodiments, in formula (1-2), $X_1$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms.

In some embodiments, in each occurrence, $R_5$ and $R_6$ are each independently selected from any one of H, D, unsubstituted alkane group having 1 to 10 carbon atoms, unsubstituted aromatic group having 6 to 15 carbon atoms, and unsubstituted heteroaromatic group having 5 to 15 carbon atoms.

In some embodiments, in each occurrence, $R_5$ and $R_6$ are each independently selected from any one of H, D, unsubstituted alkane group having 1 to 10 carbon atoms, unsubstituted aromatic group having 6 to 15 carbon atoms, and unsubstituted heteroaromatic group having 5 to 15 carbon atoms.

In some embodiments, in each occurrence, $R_5$ and $R_6$ are each independently selected from any one of H, D, unsubstituted alkane group having 1 to 5 carbon atoms, unsubstituted aromatic group having 6 to 10 carbon atoms, and unsubstituted heteroaromatic group having 5 to 10 carbon atoms.

In some embodiments, in each occurrence, $R_5$ and $R_6$ are each independently selected from any one of H, D, unsubstituted straight-linear alkane group having 1 to 5 carbon atoms, unsubstituted aromatic group having 6 to 10 carbon atoms, and unsubstituted heteroaromatic group having 5 to 10 carbon atoms.

In some embodiments, in each occurrence, $R_5$ and $R_6$ are each independently selected from any one of H, D, methyl, ethyl, propyl, isopropyl, n-butyl, tert-butyl, phenyl, naphthyl, anthracyl, pyridyl, pyrimidyl, imidazolyl, furyl, thienyl, and carbazolyl.

In some embodiments, in formula (1-2), $X_1$ is selected from any one of single bond and O.

In some embodiments, in formula (1-3), $Ar_5$ and $Ar_6$ are identically selected from any one of H, substituted or unsubstituted heteroaromatic group having 5 to 40 ring atoms, and substituted or unsubstituted aromatic group having 6 to 40 ring atoms.

In some embodiments, in formula (1-3), $Ar_5$ and $Ar_6$ are identically selected from any one of H, substituted or unsubstituted heteroaromatic group having 5 to 30 ring atoms, and substituted or unsubstituted aromatic group having 6 to 30 ring atoms.

In some embodiments, in formula (1-3), $Ar_5$ and $Ar_6$ are identically selected from any one of H, substituted or unsubstituted heteroaromatic group having 5 to 15 ring atoms, and substituted or unsubstituted aromatic group having 6 to 15 ring atoms.

In some embodiments, in formula (1-3), $Ar_5$ and $Ar_6$ are identically selected from any one of H, unsubstituted heteroaromatic group having 5 to 15 ring atoms, and unsubstituted aromatic group having 6 to 15 ring atoms.

In some embodiments, in formula (1-3), $Ar_5$ and $Ar_6$ are identically selected from any one of H, phenyl, naphthyl, anthracyl, pyridyl, pyrimidyl, imidazolyl, furyl, thienyl, and carbazolyl.

In some embodiments, in formula (1-3), $Y_1$ and $Y_2$ are identically selected from any one of $C(R_7R_8)$, O, S, N, C=O, or S=O, and in each occurrence, $R_7$ and $R_8$ are each independently selected from any one of H, D, substituted or unsubstituted alkane group having 1 to 15 carbon atoms, substituted or unsubstituted aromatic group having 6 to 15 carbon atoms, and substituted or unsubstituted heteroaromatic group having 5 to 15 carbon atoms.

In some embodiments, in formula (1-3), $Y_1$ and $Y_2$ are identically selected from any one of $C(R_7R_8)$, O, C=O, or S=O.

In some embodiments, in formula (1-3), $Y_1$ and $Y_2$ are identically selected from any one of $C(R_7R_8)$ and O.

In some embodiments, in each occurrence, $R_7$ and $R_8$ are each independently selected from any one of H, D, unsubstituted alkane group having 1 to 10 carbon atoms, unsubstituted aromatic group having 6 to 10 carbon atoms, and unsubstituted heteroaromatic group having 5 to 10 carbon atoms.

In some embodiments, in each occurrence, $R_7$ and $R_8$ are each independently selected from any one of H, D, unsubstituted straight-linear alkane group having 1 to 10 carbon atoms, unsubstituted aromatic group having 6 to 10 carbon atoms, and unsubstituted heteroaromatic group having 5 to 10 carbon atoms.

In some embodiments, in each occurrence, $R_7$ and $R_8$ are each independently selected from any one of H, D, methyl, ethyl, propyl, isopropyl, n-butyl, tert-butyl, phenyl, naphthyl, anthracyl, pyridyl, pyrimidyl, imidazolyl, furyl, thienyl, and carbazolyl.

In some embodiments, in formula (1-4), $Ar_7$ and $Ar_8$ are identically selected from any one of H, substituted or unsubstituted heteroaromatic group having 5 to 40 ring atoms, and substituted or unsubstituted aromatic group having 6 to 40 ring atoms.

In some embodiments, $Ar_7$ and $Ar_8$ are identically selected from any one of H, substituted or unsubstituted heteroaromatic group having 5 to 30 ring atoms, and substituted or unsubstituted aromatic group having 6 to 30 ring atoms.

In some embodiments, $Ar_7$ and $Ar_8$ are identically selected from any one of H, substituted or unsubstituted heteroaromatic group having 5 to 15 ring atoms, and substituted or unsubstituted aromatic group having 6 to 15 ring atoms.

In some embodiments, $Ar_7$ and $Ar_8$ are identically selected from any one of H, unsubstituted heteroaromatic group having 5 to 15 ring atoms, and unsubstituted aromatic group having 6 to 15 ring atoms.

In some embodiments, $Ar_7$ and $Ar_8$ are identically selected from any one of H, phenyl, naphthyl, anthracyl, pyridyl, pyrimidyl, imidazolyl, furyl, thienyl, and carbazolyl.

In some embodiments, in formula (1-4), $Y_3$ and $Y_4$ are identically selected from any one of $C(R_7R_8)$, O, S, N, C=O, or S=O, and in each occurrence, $R_7$ and $R_8$ are each independently selected from any one of H, D, substituted or unsubstituted alkane group having 1 to 15 carbon atoms, substituted or unsubstituted aromatic group having 6 to 15 carbon atoms, and substituted or unsubstituted heteroaromatic group having 5 to 15 carbon atoms.

In some embodiments, in formula (1-4), $X_2$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms.

In some embodiments, $X_2$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms.

In some embodiments, in each occurrence, $R_5$ and $R_6$ are each independently selected from any one of H, D, unsubstituted alkane group having 1 to 10 carbon atoms, unsubstituted aromatic group having 6 to 15 carbon atoms, and unsubstituted heteroaromatic group having 5 to 15 carbon atoms.

In some embodiments, in each occurrence, $R_5$ and $R_6$ are each independently selected from any one of H, D, unsubstituted straight-linear alkane group having 1 to 10 carbon atoms, unsubstituted aromatic group having 6 to 10 carbon atoms, and unsubstituted heteroaromatic group having 5 to 10 carbon atoms.

In some embodiments, in each occurrence, $R_5$ and $R_6$ are each independently selected from any one of H, D, unsubstituted straight-linear alkane group having 1 to 5 carbon atoms, unsubstituted aromatic group having 6 to 10 carbon atoms, and unsubstituted heteroaromatic group having 5 to 10 carbon atoms.

In some embodiments, in each occurrence, $R_5$ and $R_6$ are each independently selected from any one of H, D, methyl, ethyl, propyl, isopropyl, n-butyl, tert-butyl, phenyl, naphthyl, anthracyl, pyridyl, pyrimidyl, imidazolyl, furyl, thienyl, and carbazolyl.

In some embodiments, $X_2$ is selected from any one of single bond and O.

In some embodiments, in formulas (1-1) and (1-3), the two connection sites "*" in the

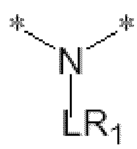

structure are bonded to a same group; and in formulas (1-2) and (1-4), the two fusion sites "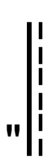" in the

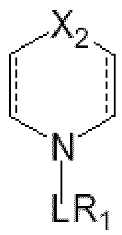

structure are fused with a same group.

In other words, in formulas (1-1) and (1-3), the groups bonded to the two connection sites "*" in

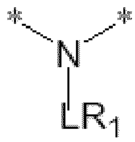

are identical, meaning that the core, the type, number, and substitution positions of the $R_2$ substituents on the groups are all identical. The same applies to formulas (1-1) and (1-3).

In some embodiments, the functional compound is represented by any one of formulas (1a) to (1e):

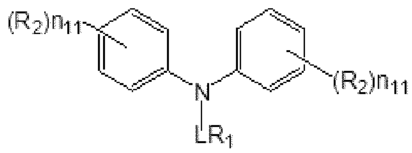

(1a)

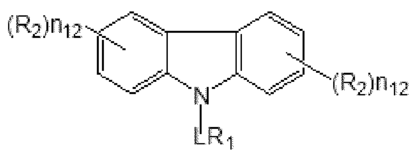

(1b)

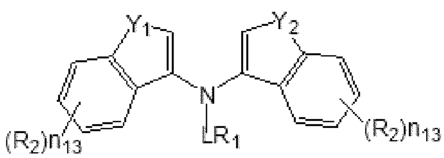

(1c)

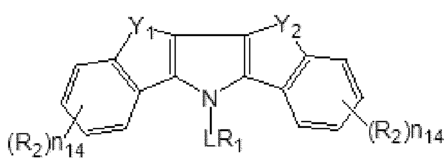

(1d)

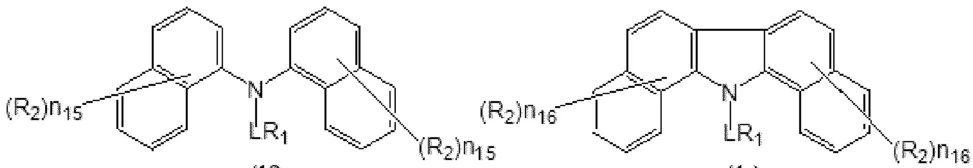

(1f) (1e)

,

where in each occurrence, $n_{11}$ or $n_{13}$ is each independently selected from any one of integers of 1 to 5, in each occurrence, $n_{12}$ or $n_{14}$ is each independently selected from any one of integers of 1 to 4, and in each occurrence, $n_{15}$ and $n_{16}$ is each independently selected from any one of integers of 1 to 6.

In some embodiments, in each occurrence, $n_{11}$ is identically selected from any one of integers from 1 to 5; in each occurrence, $n_{13}$ is identically selected from any one of integers from 1 to 5; in each occurrence, $n_{12}$ is identically selected from any one of integers from 1 to 4; in each occurrence, $n_{14}$ is identically selected from any one of integers from 1 to 4; in each occurrence, $n_{15}$ is identically a selected from any one of integers from 1 to 6; and in each occurrence, $n_{16}$ is identically selected from any one of integers from 1 to 6.

The value of any one of integers from 1 to 5 includes 1, 2, 3, 4, or 5; the value of any one of integers from 1 to 4 includes 1, 2, 3, or 4; and the value of any one of integers from 1 to 6 include 1, 2, 3, 4, 5, or 6.

In some embodiments, in formulas (1a), (1c), and (1f), the two connection sites "*" in the

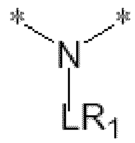

structure are bonded to a same group; and in formulas (1b), (1d), and (1e), the two fusion sites "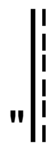" in the

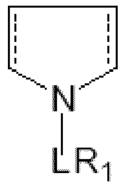

structure are fused with a same group.

In some embodiments, in each occurrence, L is independently selected from linear alkylene group having 1 to 10 carbon atoms.

In some embodiments, in each occurrence, L is independently selected from linear alkylene group having 2 to 8 carbon atoms.

In some embodiments, in each occurrence, L is independently selected from linear alkylene group having 2 to 6 carbon atoms.

In some embodiments, in each occurrence, L is independently selected from linear alkylene group having 3 to 5 carbon atoms.

In some embodiments, in each occurrence, L is independently selected from linear alkylene group having 3 to 5 carbon atoms.

In some embodiments, in each occurrence, L is independently selected from any one of methyl, ethyl, propyl, isopropyl, n-butyl, tert-butyl, pentyl, hexyl, heptyl, octyl, nonyl, and decyl.

With the length of the carbon chain in L further regulated, the functional compound maintains good hydrophobicity while achieving excellent self-assembly alignment, thereby further improving the photoconversion efficiency and stability of solar cells.

In some embodiments, in each occurrence, $R_2$ is independently selected from any one of -CHO, -CN, -C(O)$R_4$, -C(O)OH, -C(O)$NH_2$, -C(O)SH, -C(S)SH, -$NH_2$, -$NO_2$, -OH, -SH, phosphonic acid group, phosphonous acid group, sulfonic acid group, sulfinic acid group, -B$(OH)_2$, halogen, unsubstituted alkyl group having 1 to 10 carbon atoms, halogen-substituted alkyl group having 1 to 10 carbon atoms, unsubstituted alkoxy group having 1 to 10 carbon atoms, halogen-substituted alkoxy group having 1 to 10 carbon atoms, unsubstituted alkene group having 2 to 10 carbon atoms, unsubstituted alkyne group having 2 to 10 carbon atoms, unsubstituted aromatic group having 6 to 30 carbon atoms, and halogen-substituted aromatic group having 6 to 30 carbon atoms.

In some embodiments, in each occurrence, $R_2$ is independently selected from any one of phosphonic acid group, phosphonous acid group, sulfonic acid group, sulfinic acid group, -B$(OH)_2$, halogen, unsubstituted alkane group having 1 to 10 carbon atoms, halogen-substituted alkane group having 1 to 10 carbon atoms, unsubstituted alkoxy group having 1 to 10 carbon atoms, halogen-substituted alkoxy group having 1 to 10 carbon atoms, unsubstituted alkene group having 2 to 10 carbon atoms, unsubstituted alkyne group having 2 to 10 carbon atoms, unsubstituted aromatic group having 6 to 15 carbon atoms, and halogen-substituted aromatic group having 6 to 15 carbon atoms.

In some embodiments, in each occurrence, $R_2$ is independently selected from any one of phosphonic acid group, phosphonous acid group, sulfonic acid group, sulfinic acid group, -B$(OH)_2$, fluorine, chlorine, bromine, unsubstituted straight-linear alkyl group having 1 to 10 carbon atoms, halogen-substituted alkane group having 1 to 10 carbon atoms, unsubstituted alkoxy group having 1 to 10 carbon atoms, halogen-substituted straight-linear alkoxy group having 1 to 10 carbon atoms, unsubstituted straight-linear alkene group having 2 to 10 carbon atoms, unsubstituted alkyne group having 2 to 10 carbon atoms, unsubstituted aromatic group having 6 to 15 carbon atoms, and halogen-substituted aromatic group having 6 to 15 carbon atoms.

In some embodiments, in each occurrence, $R_2$ is independently selected from any one of phosphonic acid group, phosphonous acid group, sulfonic acid group, sulfinic acid group, -B$(OH)_2$, fluorine, chlorine, bromine, methyl, ethyl, propyl, isopropyl, n-butyl, tert-butyl, pentyl, hexyl, heptyl, octyl, nonyl, decyl, trifluoromethyl, trichloromethyl, tribromomethyl, vinyl, methoxy, ethoxy, propoxy, butoxy, phenyl, naphthyl, anthracyl, pyridyl, pyrimidyl, imidazolyl, furyl, thienyl, and carbazolyl.

In some embodiments, $R_4$ is selected from any one of substituted or unsubstituted alkane group having 1 to 5 carbon atoms.

In some embodiments, $R_4$ is selected from unsubstituted alkane group having 1 to 5 carbon atoms.

In some embodiments, $R_4$ is selected from unsubstituted alkane group having 1 to 3 carbon atoms.

In some embodiments, $R_4$ is selected from any one of methyl, ethyl, propyl, isopropyl, n-butyl, tert-butyl, and pentyl.

In some embodiments, the functional compound can be prepared with reference to common organic synthesis methods in the art, and examples of its preparation methods are provided here, including but not limited to the following:

For example, the synthesis route for functional compound A containing $-C(O)NH_2$ is as follows:

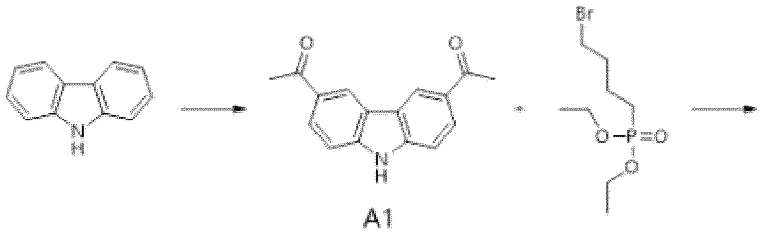

A1

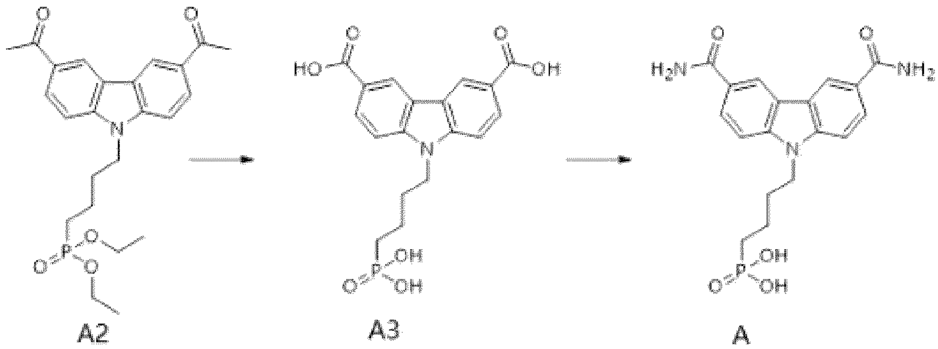

A2 A3 A

When containing -CHO, the preparation process can refer to the above process, with the first step modified to prepare the following intermediate, followed by the second step as described above, and the reaction product is hydrolyzed under reflux in NaOH solution to obtain the corresponding compound. The synthesis route for the first step is as follows:

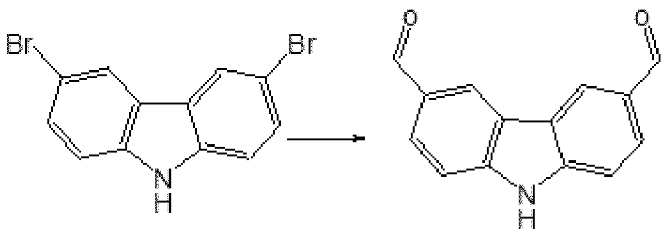

E1

When containing an acetyl group, the preparation process can refer to the above process, with the first step modified to prepare the following intermediate, with the synthesis route as follows, and the remaining steps referring to the above process:

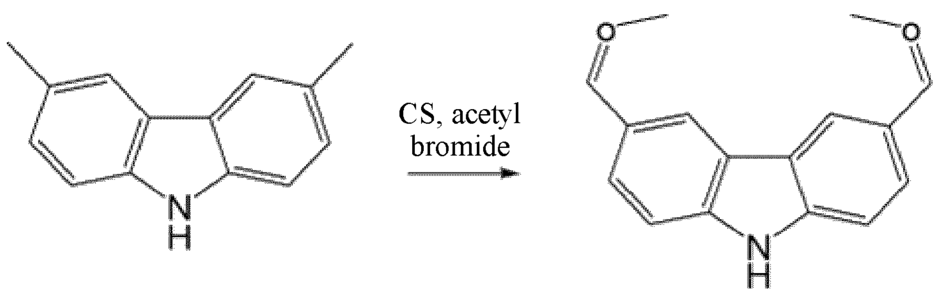

When containing -SH, the preparation process can refer to the above process, with the first step modified to prepare the following intermediate, with the synthesis route as follows, and the remaining steps referring to the above process:

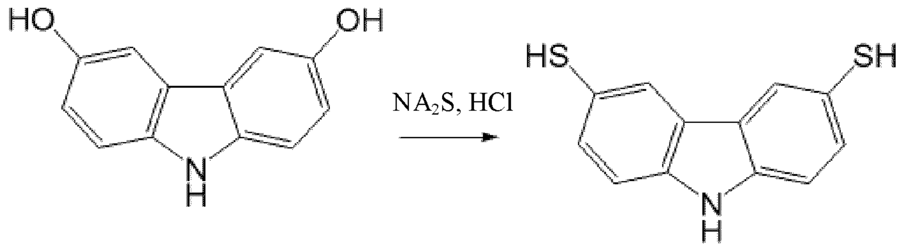


When containing -OH, 3,6-dihydroxy-9H-carbazole can be directly used to replace intermediate E1 for subsequent steps.

When containing -C(O)SH, the preparation process can refer to the above process, with the first step modified to prepare the following intermediate, with the synthesis route as follows, and the remaining steps referring to the above process:

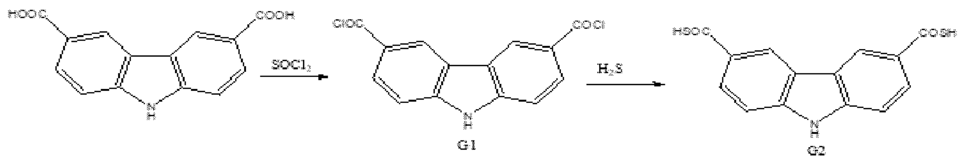


When containing -C(S)SH, the preparation process can refer to the above process, with the first step modified to prepare the following intermediate, with the synthesis route as follows, and the remaining steps referring to the above process:

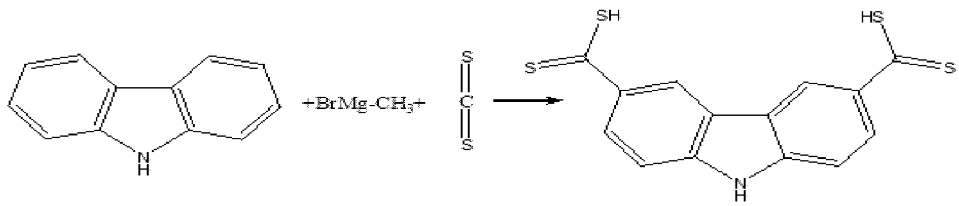


When L has different carbon chain lengths, the relevant raw materials in the second step are changed, for example, replacing 2-bromobutylphosphonic acid diethyl ester with 2-bromomethylphosphonic acid diethyl ester, 2-bromoethylphosphonic acid diethyl ester, and 2-bromohexylphosphonic acid diethyl ester, respectively, to obtain functional compounds with different carbon chain lengths for L.

Furthermore, the aldehyde group can be oxidized to obtain a carboxylic acid group. The above are merely examples, including but not limited to the above synthesis routes, and other reactions in organic synthesis methods can also be referenced to obtain the compounds.

An embodiment of the present application provides a passivation film, where the components of the passivation film include the above functional compound.

The structure of the functional compound is as described above and is not repeated here.

The above functional compound has a specific group structure, where the core portion includes a nitrogen-containing heteroaromatic group or an aromatic amine group with low hydrophilicity, substituted by $n_2$ $R_2$ groups. Additionally, at least one nitrogen atom in the core is bonded to $R_1$ via L, forming an organic whole. L is selected from linear alkylene group having 1 to 10 carbon atoms, and $R_1$ and $R_2$ are specific functional groups that can either coordinate with metal ions such as trivalent nickel, anchor to the hole transport layer, or form hydrogen bond interactions with A-site cations in the perovskite. This enables passivation of metal ions, while L reduces steric hindrance. The organic compound formed by the organic combination of Ar, L, and $R_1$ can self-assemble through intermolecular interactions to form aggregates with an ordered structure, thereby forming a relatively smooth passivation film. When used in the preparation of solar cells, it can enhance the photoelectric conversion efficiency and stability of solar cells.

The above functional compound has a specific group structure, where the core portion includes a nitrogen-containing heteroaromatic group or an aromatic amine group with low hydrophilicity, substituted by $n_2$ $R_2$ groups.

Additionally, at least one nitrogen atom in the core is bonded to $R_1$ via L, forming an organic whole. L is selected from linear alkylene group having 1 to 10 carbon atoms, and $R_1$ and $R_2$ are specific functional groups that can either coordinate with metal ions such as trivalent nickel, anchor to the hole transport layer, or form hydrogen bond interactions with A-site cations in the perovskite. This enables passivation of metal ions, while L reduces steric hindrance. The organic compound formed by the organic combination of Ar, L, and $R_1$ can self-assemble through intermolecular interactions to form aggregates with an ordered structure, thereby enhancing the photoelectric conversion efficiency and stability of solar cells when used in preparation of solar cells.

In some embodiments, the thickness of the passivation film is 5 nm to 100 nm.

An embodiment of the present application also provides a preparation method for the above passivation film, including the following steps S10 to S20.

Step S10: Mix the functional compound and a solvent to prepare a mixture solution.

Step S20: Apply the above mixture solution on the surface of a substrate and dry it to obtain the passivation film.

In some embodiments, the solvent is an organic solvent. Further, the solvent is selected from at least one of alkane solvent, alcohol solvent, aromatic solvent, amide solvent, and sulfoxide solvent.

In some embodiments, the solvent is selected from at least one of toluene, chlorobenzene, dichloromethane, methanol, isopropanol, and ethanol.

In some embodiments, the concentration of the mixture solution is 20 mg/mL to 100 mg/mL.

With the concentration of the mixture solution adjusted, the thickness of the resulting passivation film can be further regulated.

In some embodiments, the coating step can employ any one of spin-coating, spraying, blade coating, and slot-die coating method.

In some embodiments, the drying step is used to remove the solvent, which can be achieved by annealing or vacuum heating.

Referring to FIG. 1, the present application provides a solar cell 10, where the solar cell 10 includes a hole transport layer 12, a passivation layer 13, and a perovskite light-emitting layer 14 that are stacked, and the passivation layer 13 includes the above functional compound.

The structure of the functional compound is as described above and is not repeated here.

It can be understood that the metal oxides in the hole transport layer 12 can be various commonly used hole transport materials in the art, including but not limited to at least one of the following materials and their derivatives: nickel oxide, zinc oxide, molybdenum oxide, 2,2',7,7'-tetrakis(N,N-di-p-methoxyphenylamino)-9,9'-spirobifluorene (Spiro-OMeTAD), poly[bis(4-phenyl)(2,4,6-trimethylphenyl)amine] (PTAA), [4-(3,6-dimethyl-9H-carbazol-9-yl)butyl]phosphonic acid (Me-4Pacz).

In some embodiments, the components of the hole transport layer 12 include at least one of nickel oxide, zinc oxide, and molybdenum oxide.

The functional compound in the passivation layer 12 can either coordinate with metal ions such as trivalent nickel, anchor to the hole transport layer, or form hydrogen bond interactions with A-site cations in the perovskite, thereby enabling passivation of metal ions, while L reduces steric hindrance. The organic compound formed by the organic combination of Ar, L, and $R_1$ can self-assemble through intermolecular interactions to form aggregates with an ordered structure, thereby enhancing the photoelectric conversion efficiency and stability of solar cells when used in preparation of solar cells.

It can be understood that the components of the perovskite layer 14 include commonly used perovskite materials in the art.

In some embodiments, the chemical formula of the perovskite material satisfies $ABX_3$ or $A_2CDX_6$, where A is an inorganic cation, an organic ammonium cation, or a mixture thereof, and can be at least one of formamidinium ion (FA), methylammonium ion (MA), and Cs. B is an inorganic metal cation, and can be at least one of Pb ion and Sn ion. C is a noble metal cation, commonly $Ag^+$. D is a heavy metal or rare metal cation, and can be at least one of bismuth ion $Bi^{3+}$, antimony ion $Sb^{3+}$, and indium ion $In^{3+}$. X is oxygen or a halogen element, and can be at least one of O, Br, and I.

In some embodiments, the bandgap of the perovskite layer 14 is 1.20 eV to 2.30 eV, and the thickness is 200 nm to 1000 nm.

Still referring to FIG. 1, the solar cell 10 further includes a first electrode 11, an electron transport layer 15, and a second electrode 16.

The first electrode 11 is disposed on a surface of the hole transport layer 12 away from the passivation layer 13, the electron transport layer 15 is disposed on a surface of the perovskite layer 14 away from the passivation layer 13, and the second electrode 16 is disposed on a surface of the electron transport layer 15 away from the perovskite layer 14.

In some embodiments, the first electrode 11 is a transparent conductive electrode, and the material of the first electrode 11 can be any one of fluorine-doped tin oxide (FTO), tin-doped indium oxide (ITO), boron-doped zinc oxide (BZO), aluminum-doped zinc oxide (AZO), and IZO.

In some embodiments, components of the electron transport layer 15 can be commonly used electron transport

materials in the art, with non-limiting examples including: [6,6]-phenyl-C61-butyric acid methyl ester (PC61BM), [6,6]-phenyl-C71-butyric acid methyl ester (PC71BM), fullerene C60 (C60), fullerene C70 (C70), tin dioxide ($SnO_2$), and zinc oxide (ZnO).

In some embodiments, the material of the second electrode 16 can be commonly used electrode materials in the art, including but not limited to the following materials: Ag, Cu, C, Au, Al, ITO, AZO, BZO, and IZO.

The solar cell can be either a normal-structure solar cell or an inverted-structure solar cell, and can be prepared using conventional solar cell preparation methods in the art. The preparation processes for a normal-structure solar cell and an inverted-structure solar cell are exemplified below, including but not limited to the following preparation methods:

The preparation method for a normal-structure solar cell includes the following steps:
A transparent conductive glass substrate is etched, cleaned, and dried for later use to form a first electrode. An electron transport layer is prepared on the first electrode. A perovskite layer is prepared on a surface of the electron transport layer away from the first electrode. A passivation layer and a hole transport layer are sequentially formed on the surface of the perovskite layer away from the electron transport layer. A second electrode is prepared on a surface of the hole transport layer away from the passivation layer to prepare a normal-structure solar cell.

The preparation method for an inverted-structure solar cell includes the following steps:
A transparent conductive glass substrate is etched, cleaned, and dried for later use to form a second electrode. A hole transport layer is prepared on the second electrode. A passivation layer and a perovskite layer are sequentially prepared on a surface of the hole transport layer away from the second electrode. An electron transport layer is prepared on a surface of the perovskite layer away from the passivation layer. A second electrode is formed on a surface of the electron transport layer away from the perovskite layer to prepare an inverted-structure solar cell.

The components used for preparing the passivation layer include the above functional compound. For the specific preparation process, reference can be made to the preparation process of the passivation film described above. Details are not repeated herein again.

The preparation processes for the first electrode, hole transport layer, perovskite layer, electron transport layer, and second electrode can employ commonly used preparation methods in the art, including the solution method and solid deposition method. The solution method includes any one of spin-coating, spraying, blade coating, and slot-die coating method, and the solid deposition method includes any one of vacuum evaporation, sputtering deposition, plasma deposition, and ion deposition.

An embodiment of the present application also provides a photovoltaic module, where the photovoltaic module includes the above solar cell.

The above solar cell has high photoconversion efficiency and good stability, which can improve the efficiency of the photovoltaic module.

The photovoltaic module includes one or more solar cells, which can be selected based on specific application scenarios. Further, the photovoltaic module includes a plurality of solar cells, and the plurality of solar cells are connected in series or parallel to form a cell piece.

In some embodiments, the photovoltaic module further includes a photovoltaic glass layer, an adhesive layer, and a backsheet.

The two surfaces of the cell piece are respectively provided with an adhesive layer, a backsheet is provided on the surface of one adhesive layer away from the cell piece, and a photovoltaic glass layer is provided on the surface of the other adhesive layer away from the cell piece.

The photovoltaic glass layer and the backsheet are used to protect the solar cell, providing sealing, insulation, and waterproofing. The adhesive layer serves to bond the photovoltaic glass layer to the cell piece and the backsheet to the cell piece.

Optionally, the material of the photovoltaic glass layer is tempered glass, the material of the backsheet is TPT (polyvinyl fluoride) or TPE (thermoplastic elastomer), and the material of the adhesive layer is EVA (ethylene-vinyl acetate copolymer).

Further, the photovoltaic module also includes a junction box and an outer frame.

The junction box is used to protect the power generation system of the entire photovoltaic module, acting as a current transfer station. When a cell piece experiences a short circuit, the junction box automatically disconnects the shortcircuited cell string.

The outer frame can support and protect the entire photovoltaic module, and the frame can be made of aluminum alloy, offering excellent strength and corrosion resistance.

Further, silicone is used to bond and seal the connections between the frame and other parts of the photovoltaic module. The photovoltaic module can convert solar energy into electrical energy, store it in a battery, or drive a load.

In some embodiments, the photovoltaic module is a solar panel.

An embodiment of the present application also provides a photovoltaic system, including the above photovoltaic module.

The photovoltaic system utilizes the photovoltaic effect of the solar cells in the above photovoltaic module to

directly convert solar radiation energy into electrical energy, achieving high efficiency. Further, the photovoltaic system is a photovoltaic power generation system.

The photovoltaic module is the core component of the photovoltaic power generation system, and the photovoltaic system includes one or more photovoltaic modules, which can be selected based on specific application scenario. Further, when the photovoltaic system includes a plurality of photovoltaic modules, the plurality of photovoltaic modules form a photovoltaic array.

The photovoltaic system can be an independent photovoltaic power generation system or a grid-connected photovoltaic power generation system.

An independent photovoltaic power generation system includes a photovoltaic array, a battery pack, a charge controller, a power electronic converter (inverter), and a load. Its working principle is that solar radiation energy is first converted into electrical energy by the photovoltaic array, then transformed by the power electronic converter to supply the load, while excess electrical energy is stored in the energy storage device in the form of chemical energy through the charge controller. When sunlight is insufficient, the energy stored in the battery can be converted into AC 220V, 50 Hz electrical energy through the power electronic inverter, filter, and power frequency transformer for use by AC loads.

A grid-connected photovoltaic power generation system includes a photovoltaic array, a high-frequency DC/DC boost circuit, a power electronic converter (inverter), and system monitoring. Its working principle is that solar radiation energy is converted by the photovoltaic array, transformed into high-voltage DC through high-frequency DC conversion, and then inverted by the power electronic inverter to output sinusoidal AC current synchronized with the grid voltage frequency to the grid.

The above two photovoltaic power generation systems each have their own characteristics and can be selected based on specific application scenarios.

The present application is described below with reference to specific embodiments, but the present application is not limited to the following embodiments. It should be understood that the appended claims summarize the scope of the present application, and under the guidance of the concept of the present application, those skilled in the art should recognize that certain changes made to the embodiments of the present application are covered by the spirit and scope of the claims of the present application.

The following are specific examples.

Example 1

Preparation of the functional compound A, with the preparation route as follows:

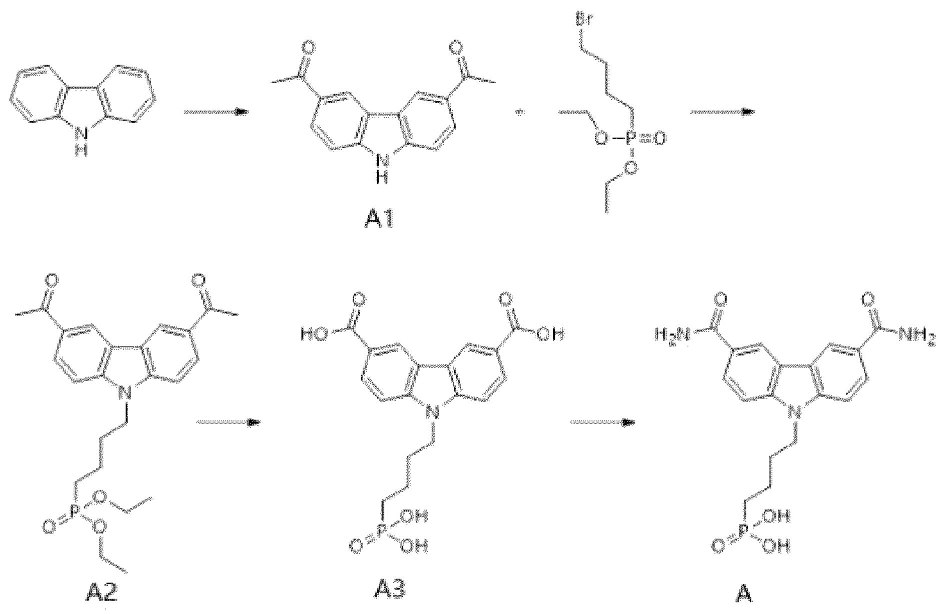

A1

A2 A3 A

The specific preparation process is as follows:

1. $AlCl_3$ (23.9 g, 179.4 mmol) and acetyl chloride (21.3 mL, 299 mmol) were suspended in 200 mL of dichloromethane, stirred, and cooled to 0°C. Then, 9H-carbazole (10 g, 59.8 mmol) was added in portions within 0.5 h. The resulting reaction mixture was heated to room temperature and stirred for 3 hours. The reaction mixture was poured into 1 L of

deionized water and transferred to a separatory funnel, and the organic layer was collected. In addition, the aqueous layer was extracted with DCM (3 × 50 mL), and the extracted organic phases were combined with the previously collected organic layer to obtain an organic component. The organic component was dried with anhydrous $MgSO_4$, and the solvent was removed by rotary evaporation to collect 14 g of solid product A1.

The product A1 was subjected to hydrogen 1 nuclear magnetic resonance testing, with the results as follows: $^1H$ NMR (400 MHz, DMSO-d6) δ: 12.1 (s, 1 H), 9.0 (d, J = 1.6 Hz, 2 H), 8.1 (dd, J = 1.6, 8.8 Hz, 2 H), 7.6 (d, J = 8.4 Hz, 2 H), 2.7 (s, 6H).

Based on the above results, the target product was successfully obtained through the preparation step, and the yield of the product A1 was calculated as 93% using the following formula:

$$\text{yield} = \text{moles of product A1} / \text{moles of 9H-carbazole} \times 100\%$$

2. 1.5 g of product A1 was dissolved in 45 mL of acetone, then 2.7 g of $K_2CO_3$ was added, and the mixture was refluxed for 1.5 h. Then, 1.47 g of 2-bromobutylphosphonic acid diethyl ester was added, and the mixture was stirred at 60°C overnight. The solvent was removed under reduced pressure to obtain a crude product, and the crude product was separated by silica gel chromatography using a mixture solution of ethyl acrylate and $CH_3OH$ in a volume ratio of 15:1 as the eluent, yielding a light brown solid product A2.

3. The product A2 (0.42 g) was added to 20 mL of 0.5 M NaClO aqueous solution. The mixture was heated at 50°C for 12 hours. The resulting solution was quenched with a $Na_2SO_3$ aqueous solution, and filtered to remove solids, and the filtrate was collected. A NaOH (0.43 g) solution was added to the filtrate and refluxed for 4 hours, and then acidified with 5 M HCl solution. The white precipitate was collected, washed with water, and dried under vacuum to obtain a product A3.

The product A3 was subjected to hydrogen 1 nuclear magnetic resonance testing, with the test results as follows: $^1H$ NMR (400 MHz, DMSO-d6): 1.07 (3H, t, J = 8 Hz), 2.22 (2H, m), 3.86 (2H, m), 4.67 (2H, d, J = 8 Hz), 7.73 (2H, d, J = 12 Hz), 8.13 (2H, d, J = 8 Hz), 8.89 (2H, d, J = 16 Hz).

Based on the above results, the target product was successfully obtained in the preparation step, where some H did not appear because H ion exchange was conducted between the deuterated reagent used in nuclear magnetic resonance and active hydrogens on the acid group.

4. The product A3 (600 mg) was added to 6 mL of dry DMF, and triethylamine ($NET_3$, 0.84 mL, 6 mmol) was added to the solution, followed by O-(7-azabenzotriazol-1-yl)-N,N,N',N'-tetramethyluronium hexafluorophosphate HATU (0.76 g, 2 mmol). The reaction mixture was stirred for 5 minutes, then solid $NH_4Cl$ (0.32 g, 6 mmol) was added, and the mixture was stirred at room temperature overnight. The reaction mixture was filtered, and the filtrate was treated with 60 mL of $H_2O$ and stirred for 30 minutes. Filtering was performed to obtain 450 mg of crude product. The crude product was recrystallized from a mixture solution of $CH_2Cl_2$ and MeOH in a volume ratio of 1:12 to obtain a functional compound A.

The functional compound A was subjected to hydrogen 1 nuclear magnetic resonance testing, with the test results as follows:

$^1H$ NMR (400 MHz, DMSO-d6): 1.26 (2H, pent), 1.66 (2H, t), 1.74 (2H, m), 4.16 (2H, t), 4.80 (2H, s), 7.65 (2H, d), 7.79 (2H, d), 8.48 (4H, s), 8.80 (2H, s).

Based on the above results, the functional compound A was successfully obtained in the preparation step.

(2) Preparation of solar cell, with specific steps as follows:

1. Cleaning of FTO conductive glass: A 2.0 cm × 2.0 cm FTO conductive glass was sequentially ultrasonically cleaned in deionized water, acetone, and isopropanol for 10 minutes each, and then dried for later use.
2. Preparation of electron transport layer: A 15 wt% tin oxide solution was mixed with deionized water in a mass ratio of 1:3, and the mixture was stirred at a room temperature of 25°C for 1 h. 70 μL of the mixture was spin-coated on the surface of the conductive glass, and heated at 150°C for 15 min to form an electron transport layer.
3. Preparation of perovskite layer and passivation layer: preparation of perovskite solution: A mixture solvent was prepared by mixing DMF:DMSO in a volume ratio of 4:1, CsFAMA ternary perovskite was added, and the foregoing substances were stirred magnetically at room temperature for 1 h to obtain a perovskite solution for later use.

The functional compound A was dissolved in an antisolvent isopropanol for later use.

The conductive glass spin-coated with the electron transport layer from step 2 was irradiated with UV for 15 min, 60 μL of the perovskite solution was added dropwise and spin-coated on the surface of the electron transport layer, and 600 μL of the antisolvent containing the dissolved functional compound A was spin-coated after a period. Annealing was

performed at 150°C for 1 h to form a perovskite layer and a passivation layer, respectively.

4. Preparation of hole transport layer: Li-TFSI (lithium bis(trifluoromethanesulfonyl)imide), tBP (4-tert-butylpyridine), and FK209 (tris[4-tert-butyl-2-(1H-pyrazol-1-yl)pyridine]cobalt tris(1,1,1-trifluoro-N-[(trifluoromethyl)sulfonyl] methanesulfonamide)) were added to spiro (2,2',7,7'-tetrakis(N,N-di-p-methoxyphenylamino)-9,9'-spirobifluorene). The foregoing substances were stirred for 1 h, and filtered to obtain a hole transport material solution for later use. On the surface of the passivation layer of the conductive glass spin-coated with the perovskite layer and passivation layer from step 3, 60 μL of the hole transport material solution was added dropwise and spin-coated and dried to obtain a hole transport layer.

5. Preparation of back electrode: An electrode position was scraped out from the hole transport layer of the device spin-coated with the hole transport layer from step 4. The device was placed in a deposition mask, and 80 nm of silver was evaporated in a vacuum evaporation device to obtain a complete perovskite solar cell.

6. The thickness of each functional layer in the perovskite solar cell was tested using a step profiler, with the thicknesses of the electron transport layer, perovskite layer, passivation layer, and hole transport layer being 80 nm, 750 nm, 20 nm, and 100 nm, respectively.

7. Performance test:

A solar simulator from Enlitech was used to perform I-V test on the solar cell in accordance with the national standard IEC61215: The light intensity was calibrated using a crystalline silicon solar cell to achieve one sun intensity: AM 1.5. The solar cell was connected to a digital source meter, and its photoelectric conversion efficiency was tested under illumination.

The photoelectric conversion efficiency results of the solar cell after left standing for three days and 30 days in an $N_2$ atmosphere at 65°C are shown in Table 1.

Examples 2-4

Examples 2-4 were substantially the same as Example 1, with the only difference being that the functional compound A was replaced with functional compounds B-D, respectively whose specific structures are as follows:

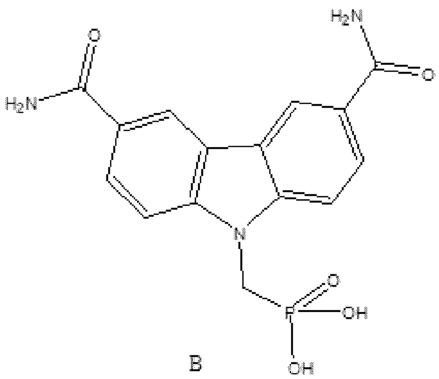

B

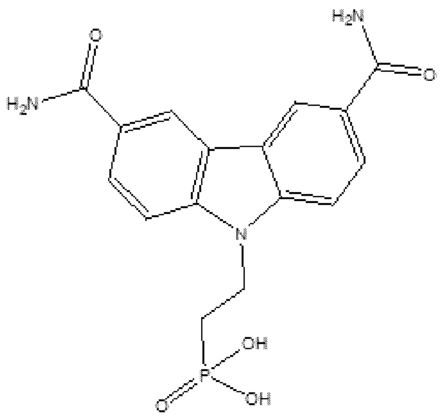

C

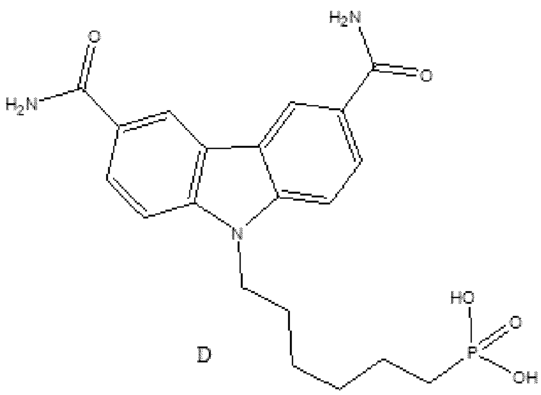

D

The preparation processes for the functional compounds B-D are similar to that of the functional compound, with the only difference being that 2-bromobutylphosphonic acid diethyl ester in the preparation process of Example 1 was

replaced with 2-bromomethylphosphonic acid diethyl ester, 2-bromoethylphosphonic acid diethyl ester, and 2-bromohexylphosphonic acid diethyl ester, respectively.

The remaining steps were the same as those in Example 1, with specific results shown in Table 1.

Examples 5-10

Examples 5-10 were substantially the same as Example 1, with the only difference being that the functional compound A was replaced with the functional compounds E-J, respectively whose specific structures are as follows:

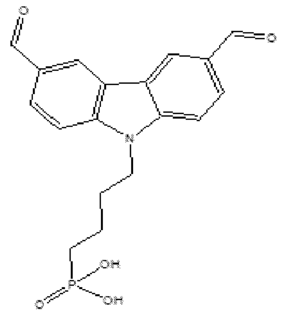

E

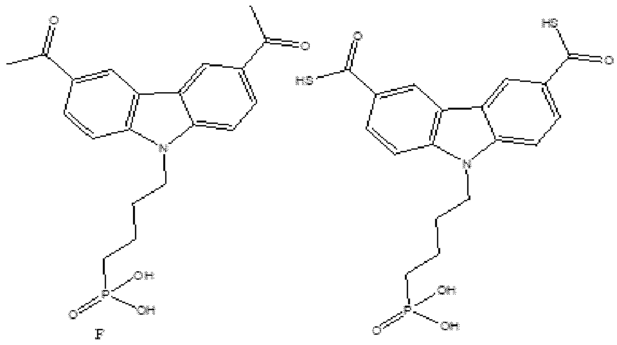

F

G

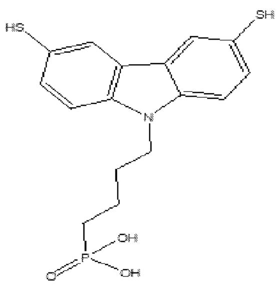

H

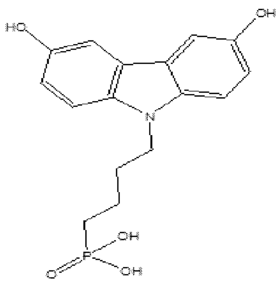

I

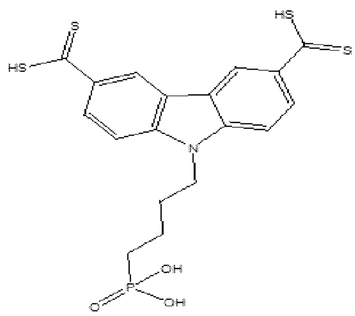

J

Specific steps are as follows.

Compound E: The preparation route is as follows: In step 1, 3,6-dibromocarbazole (1 g, 3.10 mmol) was dissolved in anhydrous THF (30 mL) to obtain a pale yellow solution. The solution was stirred at -78°C (dry ice/acetone bath). Then, 12 mL of n-BuLi solution (n-butyllithium, 1.6 M, with hexane as the solvent) was added within 10 minutes. After the color of the reaction contents darkened significantly, the reaction mixture was stirred at room temperature for 1 hour of reaction. Then, at -78°C, anhydrous DMF (2.5 mL) was added within 10 minutes, precipitating a pale yellow solid. The cooling bath was removed, and the reaction mixture was stirred for 90 minutes, followed by the addition of 20 mL of hydrochloric acid (1 M) and filtration. The filtrate was extracted repeatedly with EtOAc (5 × 50 mL), and the combined extracts were washed with brine (50 mL), dried with anhydrous sodium sulfate, and concentrated to 0.99 g of off-white solid E1, with the synthesis route as follows:

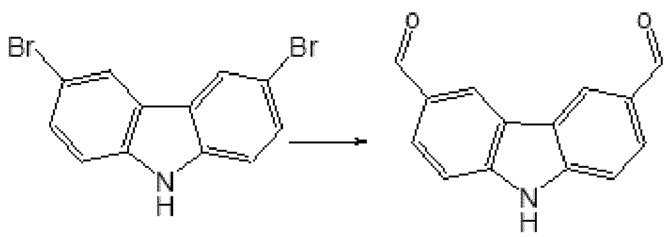

E1

The solid E1 was then used to perform the reaction in step 2 of Example 1, and the reaction product was hydrolyzed under reflux in a NaOH solution to obtain a compound E.

Compound F: Reference was made to the preparation steps for the compound E, with the difference in step 1: Under an anhydrous atmosphere, 15.0 g of acetyl bromide (12 mmol) was added dropwise to a mixture of 0.97 g (5 mmol)

carbazole, 1.60 g (12 mmol) $AlCl_3$, and 150 mL of dry CS in an ice bath. After 3 hours of reflux, the solvent was evaporated, and the residue was treated with ice-diluted HCl. The resulting product was filtered and washed with distilled water, and recrystallized from acetone to obtain 9-ethyl-3,6-diacetylcarbazole as pale yellow crystals (0.72 g), with the synthesis route as follows:

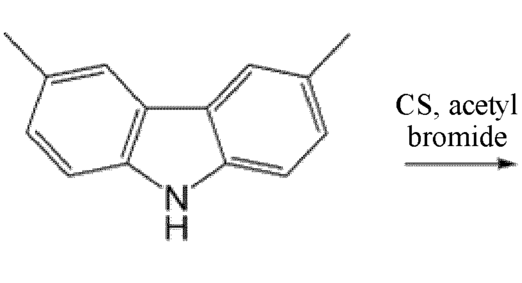


For the remaining steps, reference was made to the preparation steps for the compound E.

Compound G: For the preparation steps, reference was made to the compound E, with the difference in step 1: 12.75 g (0.05 mol) of 3,6-carbazoledicarboxylic acid (CAS: 3215-41-6) was added to a 250 mL three-neck flask, followed by 100 mL of dry dichloromethane. Under ice bath conditions, 17.846 g (0.150 mol) of thionyl chloride was slowly added dropwise, followed by 3 to 4 drops of N,N-dimethylformamide as a catalyst. The mixture was stirred magnetically under argon and heated to 75°C for 12 h reaction. The solvent and excess thionyl chloride were removed under reduced pressure to obtain a pale yellow solid intermediate G1.

The intermediate G1 was then reacted with hydrogen sulfide to obtain an intermediate G2, with the synthesis route as follows:

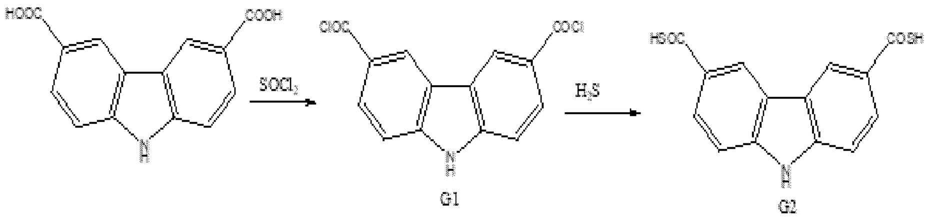


G1 G2

For the remaining steps, reference was made to the preparation steps for the compound E.

Compound H: For the preparation steps, reference was made to the compound E, with the difference in step 1: In a 150 mL flask, 1 mmol of 3,6-dihydroxy-9H-carbazole, 1.2 mmol of $Na_2S$, and 0.1 g of $NaHCO_3$ were added, and 50 mL of ethanol was added. The foregoing substances were stirred, and mixed to uniformity, then reacted under reflux for 2 hours. The reaction mixture was cooled to room temperature and filtered, and the filtrate was distilled to remove the solvent. The resulting solid mixture was recrystallized to obtain an intermediate product sodium thiolate, then an appropriate amount of 1 mol/L hydrochloric acid was added, and the acidified system was filtered, washed, and dried, and then purified by column chromatography to obtain the target 3,6-dihydroxy-9H-carbazole. The synthesis route is as follows:

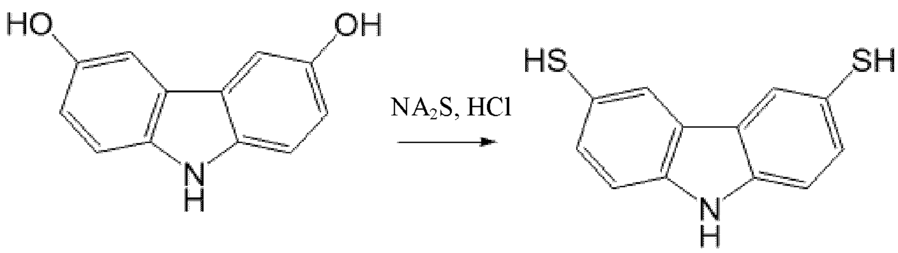


For the remaining steps, reference was made to the preparation steps for the compound E.

Compound I: For the preparation steps, reference was made to the compound E, with the difference being that step 1 was omitted, and 3,6-dihydroxy-9H-carbazole was directly used to replace intermediate E1 for subsequent steps.

For the remaining steps, reference was made to the preparation steps for the compound E.

Compound J: For the preparation steps, reference was made to the compound E, with the difference in step 1: 9H-carbazole, methylmagnesium bromide, and carbon disulfide were subjected to a nucleophilic addition reaction in

ether/DMF at 0°C to room temperature, with the preparation route as follows:

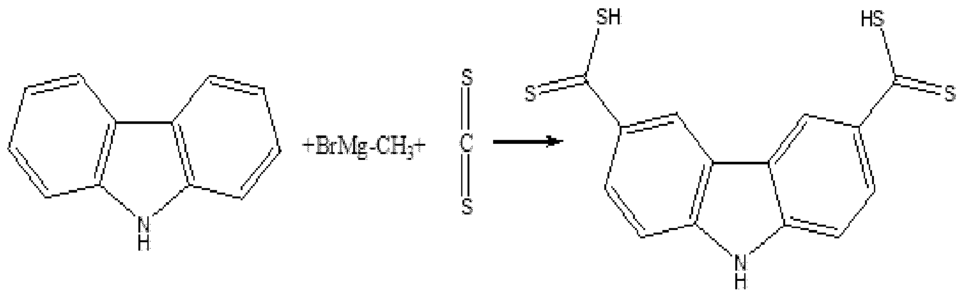


For the remaining steps, reference was made to the preparation steps for the compound E.

Examples 11 and 12

Examples 11 and 12 were substantially the same as Example 1, with the only difference being that the functional compound A was replaced with the functional compounds K-L, respectively whose specific structures are as follows:

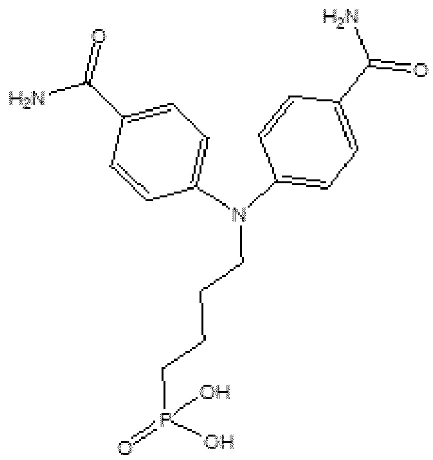
K

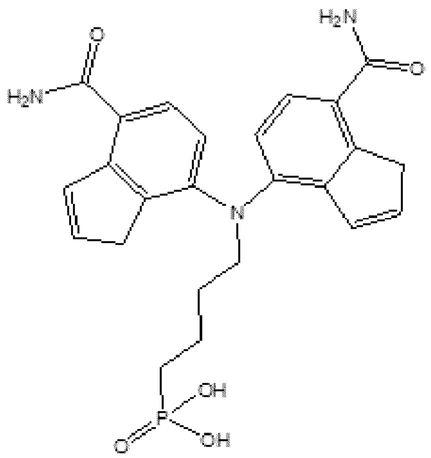
L

Specific steps are as follows.
Compound K: Reference was made to the preparation steps for the compound E, with the difference being that diphenylamine was used to replace 9H-carbazole in step 1.
Compound L: Reference was made to the preparation steps for the compound E, with the difference being that the following synthesis route was used in step 1:

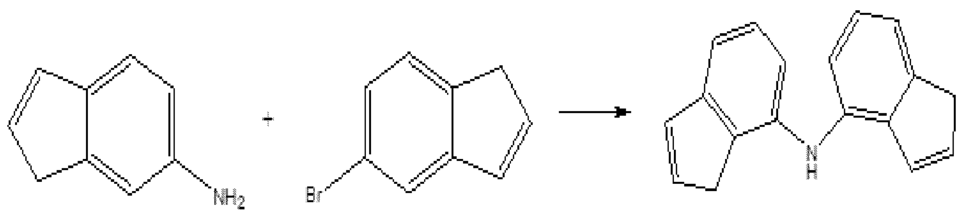

The above product was then used to replace 9H-carbazole for the reaction, with the remaining steps the same as those in Example 1.

Comparative Example 1

Comparative Example 1 was substantially the same as Example 1, with the only difference being that the functional compound A was replaced with the functional compound Q whose specific structure is as follows:

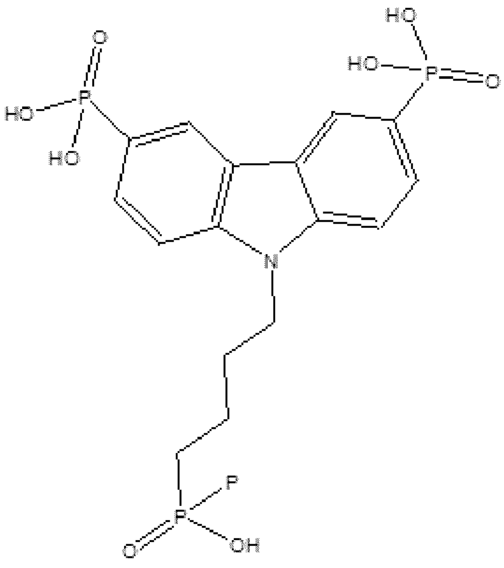

Q

For the preparation steps, reference was made to the functional compound E, with the difference being that in step 1, at 170°C under an $N_2$ atmosphere, 3,6-dibromo-9H-carbazole (5 g, 15.38 mmol) and anhydrous $NiCl_2$ (1.33 g, 10.25 mmol) were stirred in 40 mL of 1,3-diisopropylbenzene. A syringe pump was used to add triethyl phosphite (9.6 mL, 55.7 mmol) within 1 hour. Then, the reaction mixture was maintained at 170°C for 20 hours, and cooled to room temperature. The catalyst $NiCl_2$ was separated from the mixture by vacuum filtration, and then the solvent was removed by distillation. The resulting solid was dissolved in 50 mL of dichloromethane and washed with water (3 × 50 mL), and the organic phase solvent was removed by rotary evaporation. 50 mL of ether was added and the mixture was stirred for 5 minutes, followed by product filtering to obtain 3,6-bis(diethylphosphino)-9H-carbazole. The synthesis route for this step is as follows:

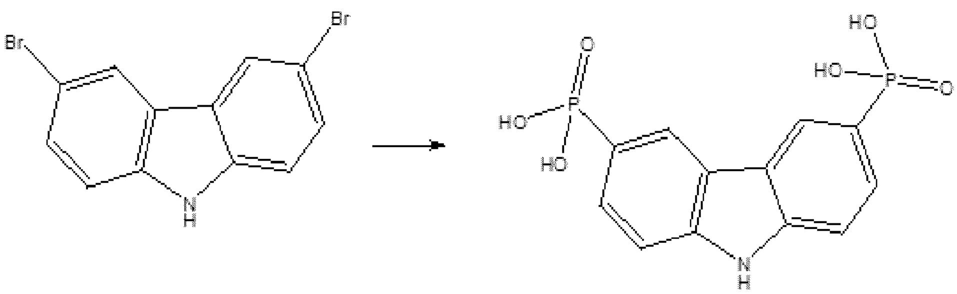

The remaining steps were the same as those for the compound E, with specific details shown in Table 1.

Comparative Example 2

Comparative Example 2 was substantially the same as Example 1, with the only difference being that the functional compound A was replaced with the functional compound R whose specific structure is as follows:

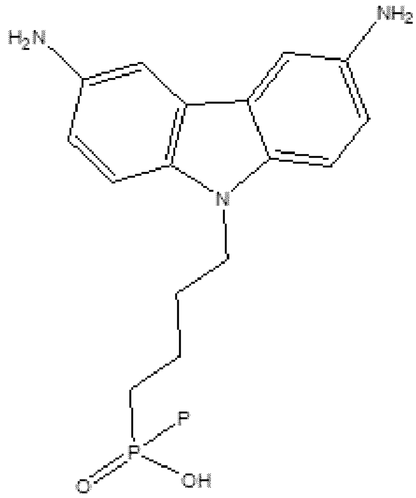

R

For the preparation steps, reference was made to the functional compound A, with the difference being that the operation in step 1 was as follows: In a 50 mL flask, 2.5 g of 3,6-dinitro-9H-carbazole was mixed with 107 mg of palladium on activated carbon (1.0 mmol), then 12 mL of ethanol was added, and the mixture was heated at reflux temperature for 1 hour. Then, 3.5 mL of hydrazine monohydrate was added, and the mixture was heated at 55°C for 36 hours. After cooling, the crude mixture was filtered and washed with ethanol, and the filtrate was dried, purified by silica gel column chromatography, first purified twice in toluene, and then purified twice in a mixture of cyclohexane/ethyl acetate (volume ratio 95/5), to obtain light brown compound 3,6-diamino-9H-carbazole.

For the subsequent synthesis steps, reference was made to steps 2 and 3 in the synthesis route for the functional compound to obtain the compound R.

The remaining steps were the same as those in Example 1, with specific details shown in Table 1.

Comparative Example 3

Comparative Example 3 was substantially the same as Example 1, with the only difference being that the functional compound A was replaced with the functional compound S whose specific structure is as follows:

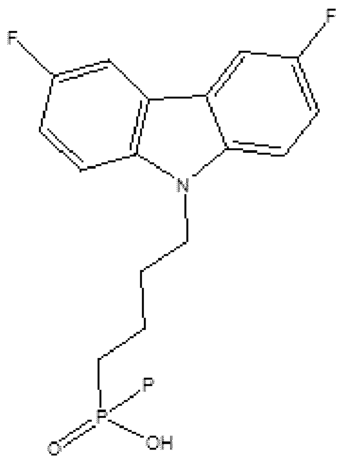

S

For the preparation steps, reference was made to the functional compound A, with the difference being that the operation in step 1 was as follows: A mixture of potassium carbonate (26.528 g, 191.9 mmol), 2-chloro-4-fluoro-N-(4-fluorophenyl)aniline (23.0 g, 96.0 mmol), tricyclohexylphosphine tetrafluoroborate (3.534 g, 9.6 mmol), palladium diacetate (1.077 g, 4.8 mmol), and anhydrous N,N-dimethylacetamide (200 mL) was stirred at 130°C under nitrogen for 16 hours. After cooling, the mixture was concentrated, the residue was treated with ethyl acetate and filtered through celite, the filter cake was washed with ethyl acetate, the filtrate was concentrated, and the residue was purified by a short silica gel column (dichloromethane/hexane volume ratio 1:1) to obtain a crude product, which was recrystallized from a 1:1

mixture of hexane-dichloromethane to obtain white powder 3,6-difluoro-9H-carbazole. The hydrogen 1 nuclear magnetic resonance data is as follows:

$^{1}H$ NMR (300 MHz, $CDCl_3$): δ 8.00 (br s, 1H), 7.67 (dd, 2H, J=8.7, 2.7 Hz), 7.36 (dd, 2H, J=8.7, 4.2 Hz), 7.19 (td, 2H, J=9.0, 2.7 Hz).

For the subsequent synthesis steps, reference was made to steps 2 and 3 in the synthesis route for functional compound to obtain the compound S.

The remaining steps were the same as those in Example 1.

Comparative Example 4

Comparative Example 4 was substantially the same as Example 1, with the only difference being that the intermediate compound A3 from Example 1 was used in Comparative Example 4 to replace the functional compound A for preparing the passivation layer.

The remaining steps were the same as those in Example 1.

Comparative Example 5

Comparative Example 5 was substantially the same as Example 1, with the only difference being that the passivation layer was omitted in the solar cell of Comparative Example 5.

The remaining steps were the same as those in Example 1.

The relevant physical parameters and test results for each example and comparative example are shown in Table 1.

**Table 1**

| | Passivation layer material | Efficiency on day 3 | Efficiency on day 30 |
|---|---|---|---|
| Example 1 | A | 24.56% | 23.53% |
| Example 2 | B | 21.82% | 20.05% |
| Example 3 | C | 23.17% | 22.57% |
| Example 4 | D | 22.91% | 21.9% |
| Example 5 | E | 21.18% | 20.52% |
| Example 6 | F | 20.83% | 19.13% |
| Example 7 | G | 23.92% | 21.24% |
| Example 8 | H | 22.53% | 20.07% |
| Example 9 | I | 20.67% | 19.43% |
| Example 10 | J | 21.18% | 19.39% |
| Example 11 | K | 22.07% | 20.04% |
| Example 12 | L | 22.96% | 21.55% |
| Comparative Example 1 | Q | 19.97% | 18.09% |
| Comparative Example 2 | R | 19.64% | 18.88% |
| Comparative Example 3 | S | 19.77% | 18.71% |
| Comparative Example 4 | A3 | 19.88% | 18.1% |
| Comparative Example 5 | / | 17.50% | 15.76% |
| Note: "/" indicates the absence of the structure or substance. | | | |

From the experimental results in the above table, it can be seen that using the functional compound of the present application to prepare the passivation layer for solar cell preparation can improve the photoelectric conversion efficiency and stability of solar cells.

The technical features of the above embodiments can be arbitrarily combined. For brevity, not all possible combinations of the technical features in the above embodiments are described. However, as long as there is no

contradiction in the combination of these technical features, they should be considered within the scope of this specification.

The above embodiments only express several implementation modes of the present application, and the descriptions are specific and detailed, but they should not be construed as limiting the scope of the patent application. It should be noted that for those of ordinary skill in the art, several variations and improvements can be made without departing from the concept of the present application, and these fall within the protection scope of the present application. Therefore, the protection scope of the present application should be subject to the appended claims, and the description and drawings may be used to interpret the content of the claims.

## Claims

1. A functional compound represented by formula (1):

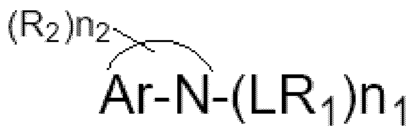

(1)

,

wherein

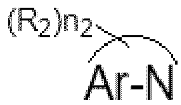

represents a nitrogen-containing heteroaromatic group having 5 to 60 ring atoms or an aromatic amine group having 6 to 60 ring atoms, substituted by $n_2$ $R_2$ groups, and at least one nitrogen atom in

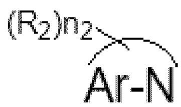

is bonded to $n_1$ $-LR_1$ groups;
in each occurrence, L is independently selected from linear alkylene group having 1 to 10 carbon atoms;
in each occurrence, $R_1$ is independently selected from any one of -CHO, -CN, $-C(O)R_4$, -C(O)OH, $-C(O)NH_2$, -C(O)SH, -C(S)SH, $-NH_2$, $-NO_2$, -OH, -SH, phosphonic acid group, phosphonous acid group, sulfonic acid group, sulfinic acid group, $-B(OH)_2$, and halogen;
in each occurrence, $R_2$ is independently selected from any one of -CHO, -CN, $-C(O)R_4$, -C(O)OH, $-C(O)NH_2$, -C(O)SH, -C(S)SH, $-NH_2$, $-NO_2$, -OH, -SH, phosphonic acid group, phosphonous acid group, sulfonic acid group, sulfinic acid group, boric acid group, halogen, substituted or unsubstituted alkyl group having 1 to 10 carbon atoms, substituted or unsubstituted alkoxy group having 1 to 10 carbon atoms, substituted or unsubstituted alkene group having 2 to 30 carbon atoms, substituted or unsubstituted alkyne group having 2 to 30 carbon atoms, and substituted or unsubstituted aromatic group having 7 to 30 carbon atoms;
in addition, at least one of all $R_1$ and $R_2$ is selected from -CHO, $-C(O)R_4$, $-C(O)NH_2$, -C(O)SH, -C(S)SH, -OH, or -SH;
in each occurrence, $R_4$ is independently selected from any one of substituted or unsubstituted alkyl group having 1 to 10 carbon atoms; and
$n_1$ is an integer ≥ 1, and $n_2$ is an integer ≥ 1.

2. The functional compound according to claim 1, wherein at least one of all $R_1$ and $R_2$ is selected from $-C(O)NH_2$.

3. The functional compound according to claim 1, wherein at least one of all $R_2$ is selected from $-C(O)NH_2$.

4. The functional compound according to any one of claims 1 to 3, wherein $n_2 \geq 2$, and at least two of all $R_2$ are selected

from -C(O)$NH_2$.

**5.** The functional compound according to any one of claims 1 to 4, wherein the functional compound is represented by any one of formulas (1-1) to (1-4):

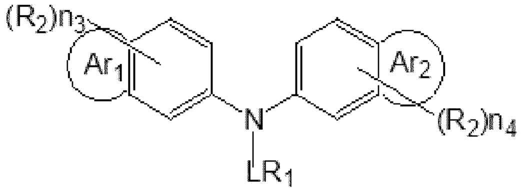

(1-1) ,

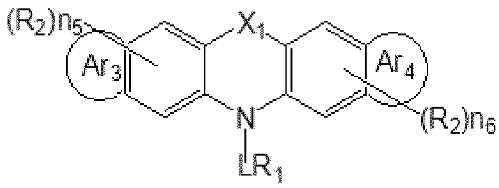

(1-2) ,

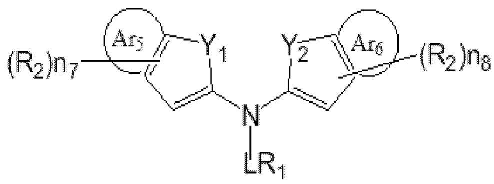

(1-3) ,

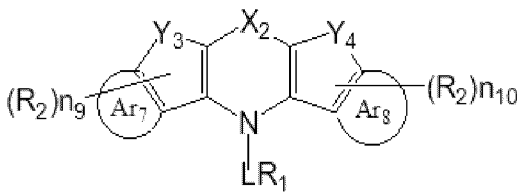

(1-4) ,

wherein $Ar_1$ to $Ar_8$ are each independently selected from any one of H, substituted or unsubstituted heteroaromatic group having 5 to 40 ring atoms, and substituted or unsubstituted aromatic group having 6 to 40 ring atoms;
$X_1$ to $X_2$ are each independently selected from any one of single bond, $C(R_5R_6)$, O, S, N, C=O, or S=O, and in each occurrence, $R_5$ and $R_6$ are each independently selected from any one of H, D, substituted or unsubstituted alkane group having 1 to 30 carbon atoms, substituted or unsubstituted aromatic group having 6 to 30 carbon atoms, and substituted or unsubstituted heteroaromatic group having 5 to 30 carbon atoms;
$Y_1$ to $Y_4$ are each independently selected from any one of $C(R_7R_8)$, O, S, N, C=O, or S=O, and in each occurrence, $R_7$ and $R_8$ are each independently selected from any one of H, D, substituted or unsubstituted alkane group having 1 to 30 carbon atoms, substituted or unsubstituted aromatic group having 6 to 30 carbon atoms, and substituted or unsubstituted heteroaromatic group having 5 to 30 carbon atoms; and
$n_3$ to $n_{10}$ are each independently an integer $\geq 0$, $n_3 + n_4 \geq 1$, $n_5 + n_6 \geq 1$, $n_7 + n_8 \geq 1$, and $n_9 + n_{10} \geq 1$.

**6.** The functional compound according to claim 5, wherein in formula (1-1), $Ar_1$ and $Ar_2$ are identically selected from any one of H, substituted or unsubstituted heteroaromatic group having 5 to 40 ring atoms, and substituted or unsubstituted aromatic group having 6 to 40 ring atoms.

**7.** The functional compound according to claim 5 or 6, wherein formula (1-2) satisfies at least one of the following conditions (1) and (2):

(1) in formula (1-2), $Ar_3$ and $Ar_4$ are identically selected from any one of H, substituted or unsubstituted heteroaromatic group having 5 to 40 ring atoms, and substituted or unsubstituted aromatic group having 6 to 40 ring atoms; and
(2) in formula (1-2), $X_1$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms.

**8.** The functional compound according to any one of claims 5 to 7, wherein formula (1-3) satisfies at least one of the following conditions (3) and (4):

(3) in formula (1-3), $Ar_5$ and $Ar_6$ are identically selected from any one of H, substituted or unsubstituted heteroaromatic group having 5 to 40 ring atoms, and substituted or unsubstituted aromatic group having 6 to 40 ring atoms; and
(4) in formula (1-3), $Y_1$ and $Y_2$ are identically selected from any one of $C(R_7R_8)$, O, S, N, C=O, or S=O, and in each occurrence, $R_7$ and $R_8$ are each independently selected from any one of H, D, substituted or unsubstituted alkane

group having 1 to 15 carbon atoms, substituted or unsubstituted aromatic group having 6 to 15 carbon atoms, and substituted or unsubstituted heteroaromatic group having 5 to 15 carbon atoms.

**9.** The functional compound according to any one of claims 5 to 8, wherein formula (1-4) satisfies at least one of the following conditions (5) to (7):

(5) in formula (1-4), $Ar_7$ and $Ar_8$ are identically selected from any one of H, substituted or unsubstituted heteroaromatic group having 5 to 40 ring atoms, and substituted or unsubstituted aromatic group having 6 to 40 ring atoms;

(6) in formula (1-4), $Y_3$ and $Y_4$ are identically selected from any one of $C(R_7R_8)$, O, S, N, C=O, or S=O, and in each occurrence, $R_7$ and $R_8$ are each independently selected from any one of H, D, substituted or unsubstituted alkane group having 1 to 15 carbon atoms, substituted or unsubstituted aromatic group having 6 to 15 carbon atoms, and substituted or unsubstituted heteroaromatic group having 5 to 15 carbon atoms; and

(7) in formula (1-4), $X_2$ is selected from any one of single bond, $C(R_5R_6)$, and O, and in each occurrence, $R_5$ and $R_6$ are each independently selected from any one of H, D, substituted or unsubstituted alkane group having 1 to 10 carbon atoms, substituted or unsubstituted aromatic group having 6 to 15 carbon atoms, and substituted or unsubstituted heteroaromatic group having 5 to 15 carbon atoms.

**10.** The functional compound according to any one of claims 5 to 9, wherein in formulas (1-1) and (1-3), the two connection sites "*" in the

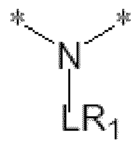

structure are bonded to a same group; and in formulas (1-2) and (1-4), the two fusion sites "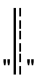" in the

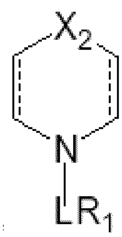

structure are fused with a same group.

**11.** The functional compound according to any one of claims 5 to 10, wherein the functional compound is represented by any one of formulas (1a) to (1e):

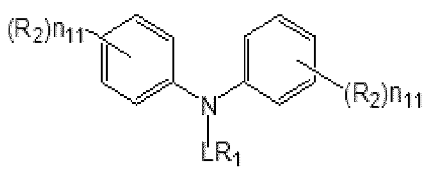

(1a)

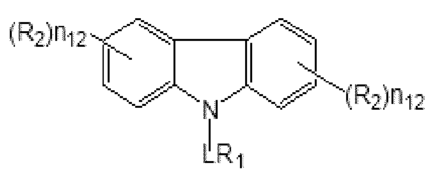

(1b)

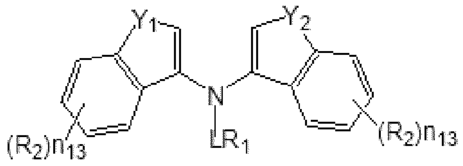

(1c)

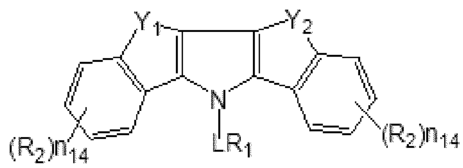

(1d)

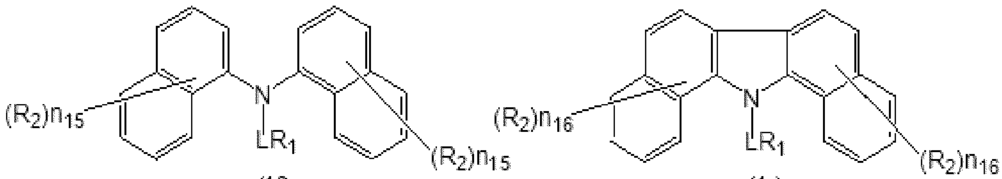

(1f) (1e)

,

wherein in each occurrence, $n_{11}$ or $n_{13}$ is each independently selected from any one of integers of 1 to 5, in each occurrence, $n_{12}$ or $n_{14}$ is each independently selected from any one of integers of 1 to 4, and in each occurrence, $n_{15}$ and $n_{16}$ is each independently selected from any one of integers of 1 to 6.

**12.** The functional compound according to any one of claims 1 to 11, wherein in each occurrence, L is independently selected from linear alkylene group having 1 to 10 carbon atoms.

**13.** The functional compound according to any one of claims 1 to 12, wherein in each occurrence, $R_2$ is independently selected from any one of -CHO, -CN, $-C(O)R_4$, -C(O)OH, $-C(O)NH_2$, -C(O)SH, -C(S)SH, $-NH_2$, $-NO_2$, -OH, -SH, phosphonic acid group, phosphonous acid group, sulfonic acid group, sulfinic acid group, $-B(OH)_2$, halogen, unsubstituted alkyl group having 1 to 10 carbon atoms, halogen-substituted alkyl group having 1 to 10 carbon atoms, unsubstituted alkoxy group having 1 to 10 carbon atoms, halogen-substituted alkoxy group having 1 to 10 carbon atoms, unsubstituted alkene group having 2 to 10 carbon atoms, unsubstituted alkyne group having 2 to 10 carbon atoms, unsubstituted aromatic group having 6 to 30 carbon atoms, and halogen-substituted aromatic group having 6 to 30 carbon atoms.

**14.** The functional compound according to any one of claims 1 to 13, wherein $R_4$ is selected from any one of substituted or unsubstituted alkane group having 1 to 5 carbon atoms.

**15.** The functional compound according to any one of claims 1 to 13, wherein the functional compound comprises at least one of the following A to L:

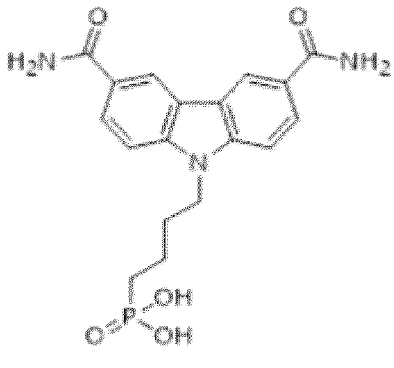

A

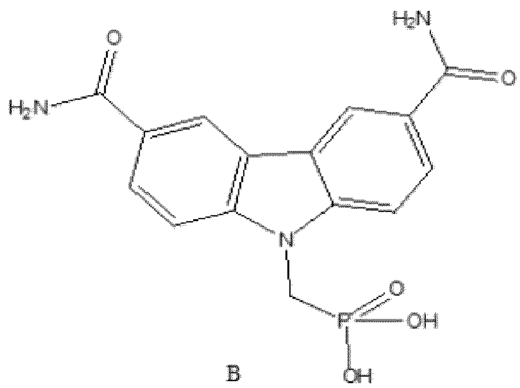

B

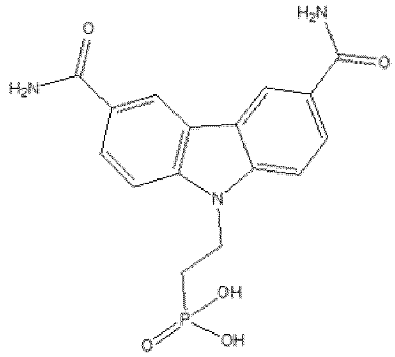

C

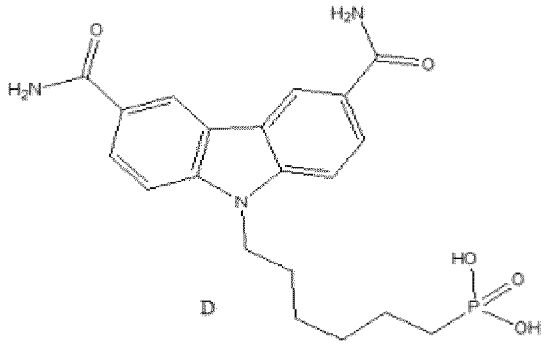

D

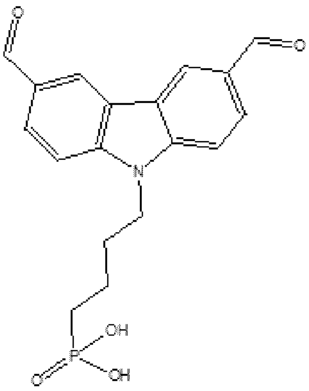

E

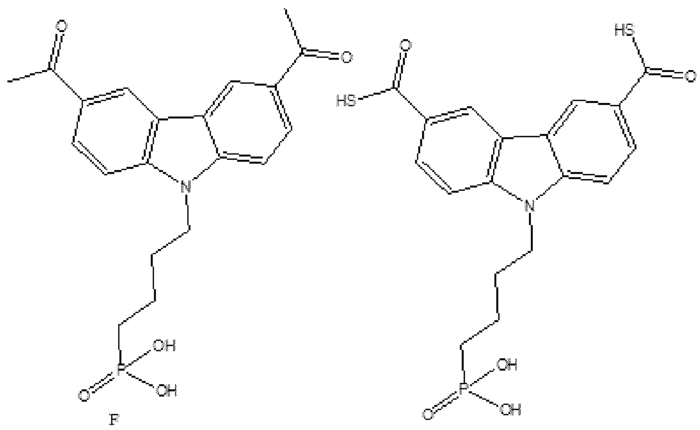

F

G

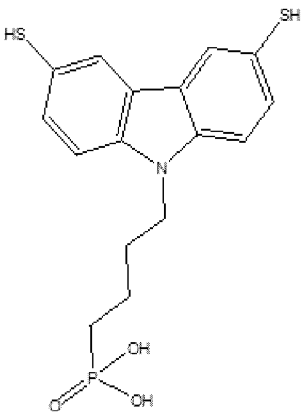

H

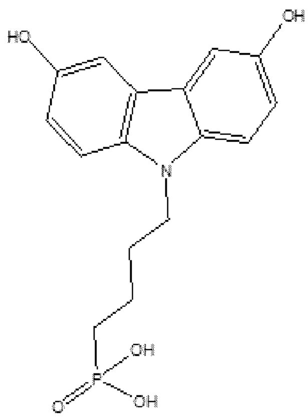

I

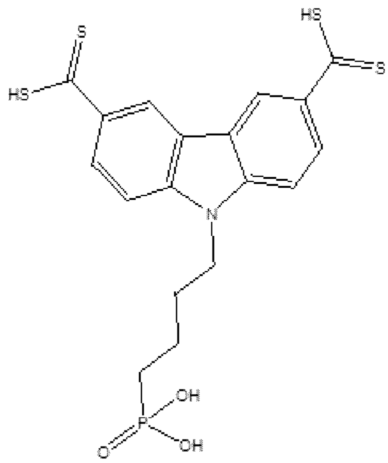

J

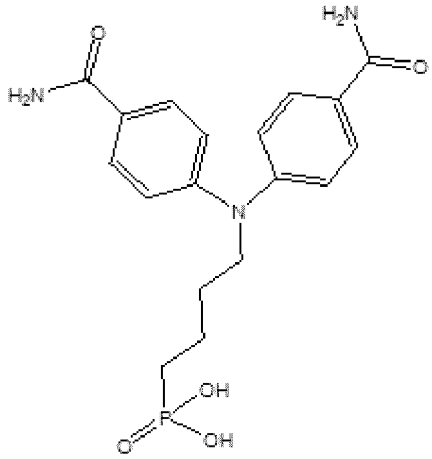

K

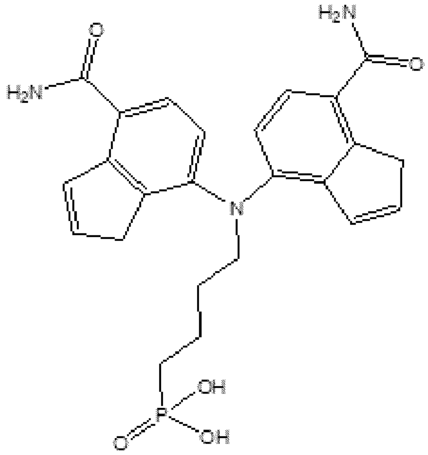

L

**16.** A passivation film, wherein a component of the passivation film comprises the functional compound according to any one of claims 1 to 15.

**17.** A solar cell, wherein the solar cell comprises a hole transport layer, a passivation layer, and a perovskite light-emitting layer that are stacked, and a component of the passivation layer comprises the functional compound according to any one of claims 1 to 15.

**18.** A photovoltaic module, comprising the solar cell according to claim 17.

**19.** A photovoltaic system, comprising the photovoltaic module according to claim 18.

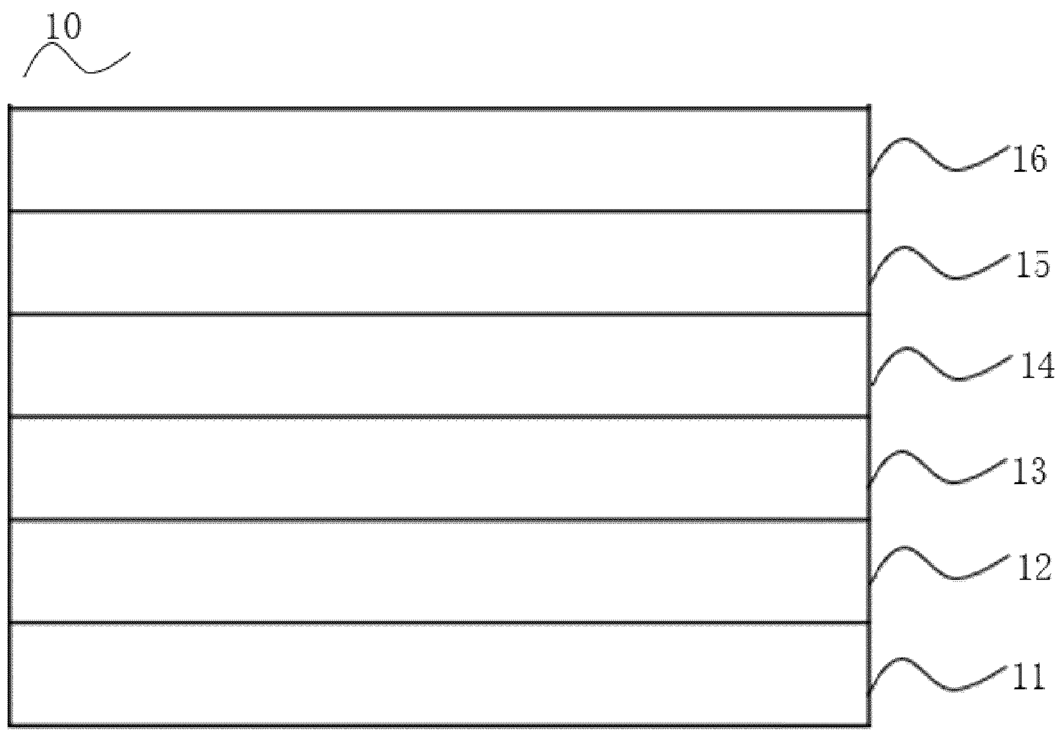


FIG. 1

**INTERNATIONAL SEARCH REPORT**

International application No.
**PCT/CN2024/076908**

**A. CLASSIFICATION OF SUBJECT MATTER**

C07F9/572(2006.01)i; H10K30/50(2023.01)i; H10K85/50(2023.01)i; H10K30/88(2023.01)i

According to International Patent Classification (IPC) or to both national classification and IPC

**B. FIELDS SEARCHED**

Minimum documentation searched (classification system followed by classification symbols)

IPC: C07F H10K

Documentation searched other than minimum documentation to the extent that such documents are included in the fields searched

Electronic data base consulted during the international search (name of data base and, where practicable, search terms used)

CNTXT, ENTXT, CNKI, STN (REG, CAPLUS): 宁德时代, 光伏, 太阳能, 膦酸, 磷酸, 咔唑, 钙钛矿, 钝化, 表面改性, 界面改性, solar, photoelectronic, +phosphonic+, +carbazol+, perovskite, 基于权利要求11的结构式检索, structural formula search based on claim 11

**C. DOCUMENTS CONSIDERED TO BE RELEVANT**

| Category* | Citation of document, with indication, where appropriate, of the relevant passages | Relevant to claim No. |
| --- | --- | --- |
| X | LIN, Yuanbao et al. "18.9% Efficient Organic Solar Cells Based on n-Doped Bulk-Heterojunction and Halogen-Substituted Self-Assembled Monolayers as Hole Extracting Interlayers" *Adv. Energy Mater.*, Vol. 12, 03 October 2022 (2022-10-03), 2202503(1-9)<br>2202503(1-9) | 1-13 |
| X | JP 2023036564 A (NATIONAL INSTITUTE FOR MATERIALS SCIENCE) 14 March 2023 (2023-03-14)<br>claims 1-3, description, paragraphs 10-12, and figure 2 | 1-14, 16-19 |
| X | JP 2023046212 A (KANEKA CORP.) 03 April 2023 (2023-04-03)<br>claim 2 | 1-14 |
| X | WO 2023003520 A2 (NANYANG TECHNOLOGICAL UNIVERSITY) 26 January 2023 (2023-01-26)<br>claim 11 | 1-14 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **27 May 2024** | **29 May 2024** |

| Name and mailing address of the ISA/CN | Authorized officer |
| --- | --- |
| **China National Intellectual Property Administration (ISA/CN)<br>China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2024/076908**

**C. DOCUMENTS CONSIDERED TO BE RELEVANT**

| Category* | Citation of document, with indication, where appropriate, of the relevant passages | Relevant to claim No. |
|---|---|---|
| X | CN 115884607 A (UNIVERSITY OF SCIENCE AND TECHNOLOGY OF CHINA) 31 March 2023 (2023-03-31)<br>embodiment 1 | 1-13 |
| PX | CN 116655682 A (JIAXING UNIVERSITY) 29 August 2023 (2023-08-29)<br>claim 1 | 1-19 |
| PX | CN 117447514 A (NANCHANG UNIVERSITY) 26 January 2024 (2024-01-26)<br>claim 1 | 1-19 |
| PX | US 2023345745 A1 (ALLIANCE FOR SUSTAINABLE ENERGY, LLC) 26 October 2023 (2023-10-26)<br>claims 1 and 7 | 1-19 |
| A | WO 2022174049 A1 (FIRST SOLAR, INC.; ALLIANCE FOR SUSTAINABLE ENERGY, LLC) 18 August 2022 (2022-08-18)<br>entire document | 1-19 |

Form PCT/ISA/210 (second sheet) (July 2022)

**INTERNATIONAL SEARCH REPORT**
**Information on patent family members**

International application No.
**PCT/CN2024/076908**

| Patent document cited in search report | Publication date (day/month/year) | Patent family member(s) | Publication date (day/month/year) |
|---|---|---|---|
| JP 2023036564 A | 14 March 2023 | None | |
| JP 2023046212 A | 03 April 2023 | None | |
| WO 2023003520 A2 | 26 January 2023 | WO 2023003520 A3 | 13 April 2023 |
| | | CN 117813933 A | 02 April 2024 |
| CN 115884607 A | 31 March 2023 | WO 2024027640 A1 | 08 February 2024 |
| | | CN 115884607 B | 17 November 2023 |
| CN 116655682 A | 29 August 2023 | None | |
| CN 117447514 A | 26 January 2024 | None | |
| US 2023345745 A1 | 26 October 2023 | None | |
| WO 2022174049 A1 | 18 August 2022 | EP 4292144 A1 | 20 December 2023 |
| | | WO 2022174049 A9 | 12 January 2023 |
| | | US 20240138163 A1 | 25 April 2024 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202310496409